(19) Europäisches Patentamt
European Patent Office
Office européen des brevets

(11) **EP 4 738 207 A1**

(12) **EUROPEAN PATENT APPLICATION**

(43) Date of publication:
06.05.2026 Bulletin 2026/19

(21) Application number: 25211514.2

(22) Date of filing: 27.10.2025

(51) International Patent Classification (IPC):
*G06N 10/70* (2022.01)

(52) Cooperative Patent Classification (CPC):
G06N 10/70

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 30.10.2024 JP 2024190486

(71) Applicant: FUJITSU LIMITED
Kawasaki-shi, Kanagawa 211-8588 (JP)

(72) Inventor: KISHI, Kaito
Kawasaki-shi, 211-8588 (JP)

(74) Representative: Haseltine Lake Kempner LLP
Cheapside House
138 Cheapside
London EC2V 6BJ (GB)

(54) **INFORMATION PROCESSING APPARATUS, COMPUTER PROGRAM, AND ERROR ESTIMATION METHOD**

(57) An information processing apparatus identifies a pair of second vertices corresponding to second qubits in which errors are detected through syndrome measurement, the pair being determined to be at a short distance based on a first determination criterion as to whether the distance between the second vertices is long or short. The information processing apparatus determines, based on first weights of first edges included in a path connecting the pair in a first decode graph, a second weight for a second edge connecting the paired second vertices. The information processing apparatus generates a second decode graph that includes the paired second vertices and a second edge connecting the paired second vertices, the second edge being assigned the second weight. Then, the information processing apparatus estimates a third qubit in which an error has occurred, based on the second weight of the second edge in the second decode graph.

FIG. 1

**Description**

FIELD

The embodiments discussed herein relate to an information processing apparatus, a computer program, and an error estimation method.

BACKGROUND

Development of quantum error correction techniques has been advanced in order to implement high-precision quantum computation on a quantum computer. To enable quantum error correction, the state of a single qubit is encoded using a plurality of physical qubits, e.g., in a surface code. The encoded single qubit is referred to as a logical qubit. Errors in the physical qubits constituting a logical qubit may be detected through syndrome measurements using ancilla qubits. The positions of physical qubits in which errors have occurred are detected by decoding the code based on the results of the syndrome measurements.

As a quantum error correction technique, for example, a qubit error estimation device has been proposed that estimates errors within a desired time and with a practical code distance, without using approximations such as assuming a constant bit error rate. Techniques have also been proposed for encoding a quantum circuit to a trivalent lattice scheme to identify flag qubit outcomes. Quantum error correction has also been proposed to correct a stream of syndrome measurements. Furthermore, an efficient method for decoding quantum state information has also been proposed. A technique of implementing a decoder responsible for diagnosing noise-induced diagnostic errors on a field-programmable gate array (FPGA) and an application specific integrated circuit (ASIC) has also been proposed. See, for example, the following literatures.

Japanese Laid-open Patent Publication No. 2024-59124
Japanese National Publication of International Patent Application No. 2022-553169
U.S. Patent Application Publication No. 2022/0382632
U.S. Patent No. 11847020

Ben Barber, et al., "A real-time, scalable, fast and highly resource efficient decoder for a quantum computer", arXiv: 2309.05558v2, quant-ph, 24-Sep-2024

When a quantum computer sequentially performs the gate operations of a plurality of quantum gates represented in a quantum circuit, it frequently performs syndrome measurements on logical qubits and the estimation of error locations based on the measurement results. Therefore, there is a demand that the computation for estimating error locations in a logical qubit is performed within a short time, for example, within 1 $\mu$s. However, conventional error location estimation algorithms have difficulty in estimating error locations within a short time due to a large amount of data used and other reasons.

SUMMARY

In one aspect, it is desirable to reduce the time needed to estimate error locations in a logical qubit.

In one aspect, there is provided an information processing apparatus including: processing unit for: generating a first decode graph including first vertices corresponding to a plurality of first qubits, respectively, and first edges each connecting the first vertices corresponding to two first qubits among the plurality of first qubits, the plurality of first qubits being used for detecting an error occurring in qubits in a qubit device, the two first qubits sharing a same qubit among the qubits as an error detection target, each of the first edges being assigned a first weight based on a probability of detecting an error with the first qubits corresponding to the first vertices at both ends of said each of the first edges; identifying, from among the plurality of first vertices, a pair of second vertices corresponding to two different second qubits among a plurality of second qubits in which errors have been detected through syndrome measurement, the second vertices of the pair having been determined to be at a short distance based on a first determination criterion as to whether a distance between the second vertices is long or short; determining a second weight for a second edge connecting the second vertices of the pair, based on the first weights of the first edges included in a path connecting the second vertices of the pair in the first decode graph; generating a second decode graph including the second vertices of the pair and the second edge connecting the second vertices of the pair, the second edge being assigned the second weight; and estimating a third qubit in which an error has occurred, based on the second weight of the second edge in the second decode graph.

BRIEF DESCRIPTION OF DRAWINGS

The invention is described, by way of example only, with reference to the following drawings, in which:

FIG. 1 illustrates an example of an error estimation method according to a first embodiment;
FIG. 2 illustrates an example of a configuration of a quantum computing system;
FIG. 3 illustrates an example of hardware of a classical computer and a quantum computer;
FIG. 4 illustrates an example of qubit encoding;
FIG. 5 illustrates an example of errors occurring in a logical qubit;
FIG. 6 illustrates an example of an error location estimation process using a decode graph;
FIG. 7 illustrates an example of an error location estimation process that causes a logical error;
FIG. 8 illustrates an example of error pattern estimation by an MWPM decoder;
FIG. 9 illustrates an example of a processing procedure performed by the MWPM decoder;
FIG. 10 illustrates an example of a method of expanding clusters;
FIG. 11 illustrates an example of decoding using an Ising model;
FIG. 12 is a block diagram illustrating an example of a quantum computation function that involves decoding using a simplified decode graph;
FIG. 13 illustrates an example procedure for computation based on a quantum circuit;
FIG. 14 is a flowchart illustrating an example procedure for a decode graph region dividing process;
FIG. 15 illustrates an example of a three-dimensional decode graph;
FIG. 16 illustrates an example of a process of dividing a decode graph;
FIG. 17 illustrates an example of a divided decode graph;
FIG. 18 illustrates an example of addresses assigned to subregions;
FIG. 19 illustrates an example of the average weight values of subregions;
FIG. 20 is a flowchart illustrating an example procedure for a decoding process;
FIG. 21 illustrates an example of a simplified decode graph;
FIG. 22 illustrates an example of the decoding process using a simplified decode graph;
FIG. 23 illustrates an accuracy evaluation result obtained when decoding is performed by MWPM using a simplified decode graph; and
FIG. 24 illustrates an evaluation result of the amount of memory used when decoding is performed by an Ising decoder using a simplified decode graph.

DESCRIPTION OF EMBODIMENTS

Hereinafter, embodiments will be described with reference to the drawings. A plurality of embodiments may be combined unless they exclude each other.

[First Embodiment]

A first embodiment relates to an error estimation method capable of estimating error locations in a logical qubit within a short time.

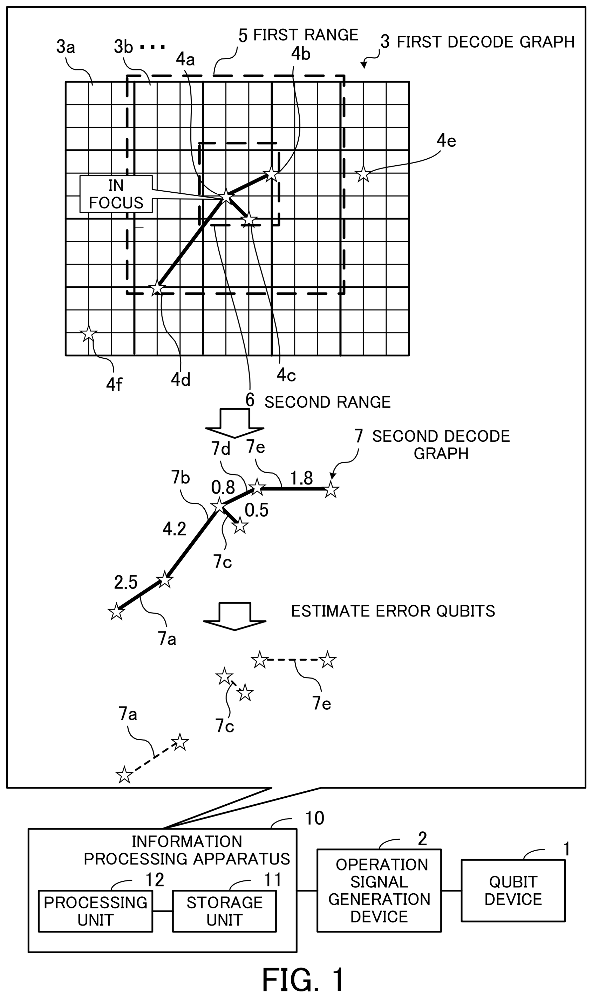

FIG. 1 illustrates an example of the error estimation method according to the first embodiment. FIG. 1 illustrates an information processing apparatus 10 for implementing the error estimation method. The information processing apparatus 10 is connected to a qubit device 1 via, for example, an operation signal generation device 2. The qubit device 1 is a device that implements a qubit, which is the minimum unit of quantum information. A plurality of qubits are implemented in the qubit device 1. The operation signal generation device 2 is a device that generates signals (for example, microwaves) for operating the states of the qubits and measuring the states.
The information processing apparatus 10 implements quantum computation using the qubit device 1 by causing the operation signal generation device 2 to generate signals in accordance with quantum gates represented in a quantum circuit that corresponds to a problem to be solved. At this time, the information processing apparatus 10 is able to implement the error estimation method according to the first embodiment by executing, for example, an error estimation program.
The information processing apparatus 10 includes a storage unit 11 and a processing unit 12. The storage unit 11 is, for example, a memory or a storage device included in the information processing apparatus 10. The processing unit 12 is, for example, a processor included in the information processing apparatus 10. The information processing apparatus 10 may include a plurality of processors. Different processes among a plurality of processes performed by the information processing apparatus 10 may be performed by different processors.
The storage unit 11 stores, for example, information on a quantum circuit to be executed (quantum gates to be executed, qubits to be used, a code distance, and others).

The processing unit 12 transmits control signals for gate operations based on the quantum circuit, to the operation signal generation device 2. When receiving measurement results of syndrome measurements for error detection from the operation signal generation device 2, the processing unit 12 performs an error detection process. The procedure for the error detection process is as follows.

The processing unit 12 generates a first decode graph 3. The first decode graph 3 includes a plurality of vertices (first vertices) and edges (first edges) connecting the first vertices. The first vertices correspond to a plurality of first qubits, respectively, which are used for detecting errors occurring in qubits in the qubit device 1. These first qubits are also referred to as ancilla qubits.

Each first edge connects two first vertices corresponding respectively to two first qubits that share the same qubit as an error detection target. Each first edge is assigned a first weight that is determined based on a probability of detecting an error with the first qubits corresponding to the first vertices at both ends of that first edge. For example, a larger first weight is set as an error is less likely to occur in an error detection target qubit.

The processing unit 12 then identifies, from among the plurality of first vertices, pairs of vertices (second vertices 4a to 4f) corresponding to two different second qubits among a plurality of second qubits in which errors have been detected through the syndrome measurements, the paired vertices having been determined to be at a short distance based on a first determination criterion as to whether the distance between the second vertices 4a to 4f is long or short. For example, the first determination criterion is a threshold value for the Manhattan distance. In this case, the processing unit 12 determines that second vertices are at a short distance if the Manhattan distance therebetween is less than or equal to the threshold value, and determines that second vertices are at a long distance from each other if the Manhattan distance therebetween exceeds the threshold value.

The processing unit 12 may divide the region where the first decode graph 3 exists into a plurality of subregions 3a, 3b, .... In this case, the processing unit 12 determines whether the distance between two second vertices under determination is long or short, based on the first determination criterion related to the positional relationship between the subregions to which the two second vertices under determination belong. Referring to the example of FIG. 1, the processing unit 12 determines that two second vertices are at a short distance, if the subregions to which the two second vertices belong are adjacent to each other. Focus now on the second vertex 4a, for example. The second vertex 4a is determined to be at a short distance from each of the second vertices 4b to 4d, which are located within a first range 5 including subregions adjacent to the subregion to which the second vertex 4a belongs, and is determined to be at a long distance from each of the other second vertices 4e and 4f.

After identifying the pairs of second vertices, the processing unit 12 determines, for each of second edges 7a to 7e each connecting paired second vertices, a second weight based on the first weights of the first edges included in a path that connects the paired second vertices in the first decode graph 3. For example, the processing unit 12 sets, for each second edge 7a to 7e connecting paired second vertices, the sum of the first weights of the first edges included in the shortest path connecting the paired second vertices in the first decode graph 3, as a second weight.

Next, the processing unit 12 generates a second decode graph 7 that includes the second vertices of each pair and the second edges 7a to 7e connecting the second vertices of the pairs, with the second edges 7a to 7e assigned the second weights. The second decode graph 7 has a simpler structure than the first decode graph 3.

Then, the processing unit 12 estimates third qubits in which errors have occurred, based on the second weights of the second edges in the second decode graph 7. For example, the processing unit 12 combines the second edges 7a to 7e of the second decode graph 7 in such a manner that each second vertex 4a to 4f becomes an endpoint of any of the second edges 7a to 7e. Among the possible combinations of the second edges 7a to 7e, the processing unit 12 identifies a combination in which the sum of the weights of the second edges 7a to 7e included in the combination is the smallest. The processing unit 12 identifies first edges included in a path on the first decode graph 3 between the second vertices at both ends of each of the second edges 7a, 7c, and 7e included in the identified combination. Then, the processing unit 12 estimates that errors have occurred in the qubits corresponding to the identified first edges.

In the manner described above, the error locations are estimated using the simplified second decode graph 7. The second decode graph 7 is very simple compared to a complete graph in which every second vertex 4a to 4f corresponding to the second qubits in which errors have been detected is connected to every other second vertex 4a to 4f. Therefore, the error location estimation based on the second decode graph 7 is performed with a smaller amount of data and within a shorter computation time than the error location estimation based on such a complete graph.

In addition, the processing unit 12 determines whether the distance between second vertices is long or short, based on the first determination criterion related to the positional relationship between the subregions 3a, 3b, ... of the first decode graph 3, which achieves the determination within a short time.

The processing unit 12 may determine the calculation method for a second weight, according to whether a second determination criterion is satisfied. The second determination criterion here is a criterion for determining that the distance between the subregions to which paired second vertices belong is short. For example, the processing unit 12 determines that the distance between paired second vertices is short if a second range 6 centered on the subregion to which one of the paired second vertices belongs includes the subregion to which the other of the paired second vertices belongs. Focusing on the second vertex 4a in the example of FIG. 1, the second range 6 is a subregion to which the second vertex 4a belongs.

The processing unit 12 determines a second weight using a first calculation method if the positional relationship between the subregions to which paired second vertices belong satisfies the second determination criterion, and determines the second weight using a second calculation method, which is less precise than the first calculation method, if the positional relationship does not satisfy the second determination criterion. Accordingly, in the case where paired second vertices are far apart, a second weight is approximately calculated within a short time. This reduces the computation time for calculating the second weight.

For example, the processing unit 12 calculates, for each of the plurality of subregions in the first decode graph 3, the average weight of the first edges in that subregion, and if the second determination criterion is not satisfied, replaces the weights of the first edges with the average weights of the subregions to which the first edges belong. The processing unit 12 then determines a second weight using the updated weights of the first edges. This reduces the computation time for calculating the second weight.

In addition, the processing unit 12 may prevent the number of pairs, each formed by each second vertex and a different second vertex (the number of second edges connected to each second vertex) from exceeding a predetermined upper limit value. This prevents the total number of second edges in the second decode graph 7 from becoming excessively large. As a result, the time for the error location estimation is reliably reduced.

[Second Embodiment]

A second embodiment relates to a quantum computing system that involves quantum error correction.

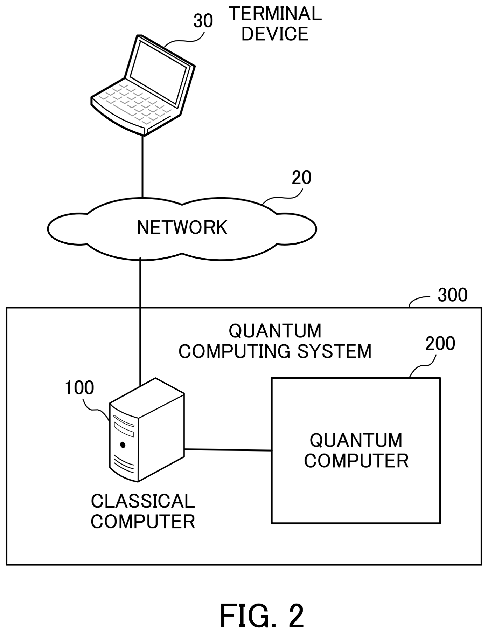

FIG. 2 illustrates an example of a configuration of a quantum computing system. The quantum computing system 300 is, for example, a computer system that performs computation using the principle of quantum mechanics. The quantum computing system 300 includes a classical computer 100 and a quantum computer 200. The classical computer 100 is a von Neumann computer. The quantum computer 200 is a non-von Neumann computer that performs quantum computation by applying quantum gates to qubits. For example, the quantum computer 200 performs quantum computation using a quantum gate method.

A terminal device 30 is connected to the classical computer 100 via a network 20. The terminal device 30 is a computer used by a user who requests quantum computation to be performed by the quantum computing system 300. The classical computer 100 receives a quantum computation request including a quantum circuit from, for example, the terminal device 30. The quantum circuit indicates an order of gate operations on qubits according to the arrangement of elements such as gates. A qubit is a bit capable of representing a superposition state of a "0" state and a "1" state.

In accordance with the quantum computation request received from the terminal device 30, the classical computer 100 instructs the quantum computer 200 to perform gate operations on qubits. The classical computer 100 acquires a measurement result of each qubit from the quantum computer 200.

The quantum computer 200 performs gate operations on qubits in accordance with instructions from the classical computer 100. The quantum computer 200 measures the states of the qubits and transmits the measurement results to the classical computer 100.

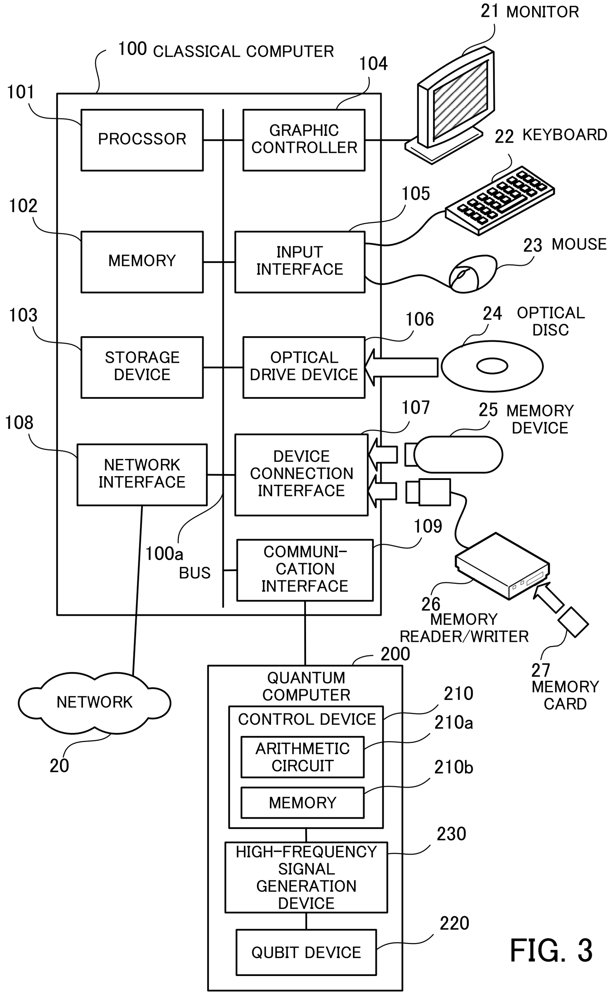

FIG. 3 illustrates an example of hardware of a classical computer and a quantum computer. The classical computer 100 is entirely controlled by a processor 101. A memory 102 and a plurality of peripheral devices are connected to the processor 101 via a bus 100a.

The classical computer 100 may be a multiprocessor system having a plurality of processors. A set of processors in a multiprocessor system may be referred to as the processor 101. The processor 101 may be referred to as processor circuitry. Each of the plurality of processors is able to perform some or all of the plurality of processes to be performed by the classical computer 100. Different processes among a plurality of related processes may be performed by different processors.

The processor 101 is, for example, a central processing unit (CPU), a micro processing unit (MPU), or a digital signal processor (DSP). At least a part of the functions implemented by the processor 101 executing the program may be implemented by an electronic circuit such as an ASIC or a programmable logic device (PLD).

The memory 102 is used as a main storage device of the classical computer 100. The memory 102 temporarily stores at least a part of operating system (OS) programs and application programs to be executed by the processor 101. The memory 102 also stores various data used for processing by the processor 101. As the memory 102, for example, a volatile semiconductor storage device such as a random access memory (RAM) is used.

The peripheral devices connected to the bus 100a include a storage device 103, a graphic controller 104, an input interface 105, an optical drive device 106, a device connection interface 107, a network interface 108, and a communication interface 109.

The storage device 103 electrically or magnetically writes and reads data to and from a built-in recording medium.

The storage device 103 is used as an auxiliary storage device of the classical computer 100. The storage device 103 stores OS programs, application programs, and various data. As the storage device 103, for example, a hard disk drive (HDD) or a solid state drive (SSD) may be used.

The graphic controller 104 is an arithmetic device that performs image processing. The graphic controller 104 is, for example, a graphics processing unit (GPU). A monitor 21 is connected to the graphic controller 104. The graphic controller 104 displays images on the screen of the monitor 21 in accordance with instructions from the processor 101. Examples of the monitor 21 include a display device using organic electro luminescence (EL) and a liquid crystal display device. In the case where, for example, a GPU is used as the graphic controller 104, the graphic controller 104 is able to perform complicated numerical calculations such as matrix calculations.

A keyboard 22 and a mouse 23 are connected to the input interface 105. The input interface 105 transmits signals received from the keyboard 22 and the mouse 23, to the processor 101. The mouse 23 is an example of a pointing device, and other pointing devices may be used. Examples of other pointing devices include a touch panel, a tablet, a touch pad, and a track ball.

The optical drive device 106 reads data recorded on an optical disc 24 or writes data to the optical disc 24 using laser light or the like. The optical disc 24 is a portable recording medium on which data is recorded so as to be readable by reflection of light. The optical disc 24 may be a digital versatile disc (DVD), a DVD-RAM, a compact disc read only memory (CD-ROM), a CD-recordable (CD-R), CD-rewritable (CD-RW), or the like.

The device connection interface 107 is a communication interface for connecting peripheral devices to the classical computer 100. For example, a memory device 25 and a memory reader/writer 26 are connected to the device connection interface 107. The memory device 25 is a recording medium having a function of communicating with the device connection interface 107. The memory reader/writer 26 is a device that writes data to a memory card 27 or reads data from the memory card 27. The memory card 27 is a card-type recording medium.

The network interface 108 is connected to the network 20. The network interface 108 transmits and receives data to and from other computers or communication devices via the network 20. The network interface 108 is a wired communication interface connected to a wired communication device such as a switch or a router via a cable. Alternatively, the network interface 108 may be a wireless communication interface communicatively connected to a wireless communication device such as a base station or an access point by radio waves.

The communication interface 109 is connected to the quantum computer 200. The communication interface 109 communicates with the quantum computer 200. The communication interface 109 transmits a quantum gate operation instruction based on a quantum circuit to, for example, the quantum computer 200. The communication interface 109 receives an execution result of the quantum circuit from the quantum computer 200.

Having the hardware as described above, the classical computer 100 is able to implement the processing functions of the second embodiment. The apparatus described in the first embodiment may also be implemented with hardware similar to that of the classical computer 100 illustrated in FIG. 3.

The classical computer 100 implements the processing functions of the second embodiment by executing a program recorded on a computer-readable recording medium, for example. The program describing the processing contents to be executed by the classical computer 100 may be recorded on various recording media. For example, a program to be executed by the classical computer 100 may be stored in the storage device 103. The processor 101 loads at least a part of the program from the storage device 103 into the memory 102 and executes the program. The program to be executed by the classical computer 100 may be stored in a portable recording medium such as the optical disc 24, the memory device 25, or the memory card 27. The program stored in the portable recording medium becomes executable after being installed in the storage device 103 under the control of the processor 101, for example. Alternatively, the processor 101 may read the program directly from the portable recording medium and execute the program.

The quantum computer 200 includes a control device 210, a qubit device 220, and a high-frequency signal generation device 230. Although the control device 210 is provided in the quantum computer 200, it is a classical computer in principle.

The control device 210 performs gate operations on the qubits in the qubit device 220 in accordance with instructions from the classical computer 100. For example, the control device 210 transmits, to the high-frequency signal generation device 230, a control signal instructing emission of a microwave having a predetermined frequency to a qubit.

The control device 210 includes an arithmetic circuit 210a and a memory 210b. The arithmetic circuit 210a is a processor, a logic circuit such as an ASIC, or a combination thereof. The arithmetic circuit 210a performs a decoding process based on, for example, results of syndrome measurements, and determines the presence or absence of an error in a logical Z operator or a logical X operator. The memory 210b stores, for example, data used for the decoding.

The qubit device 220 has a plurality of qubits. The qubit device 220 has superconducting qubits, trapped-ion qubits, cold atom qubits, or others. The qubit device 220 may also be referred to as a quantum processing unit (QPU).

The high-frequency signal generation device 230 generates a high-frequency signal for operating or measuring a qubit in the qubit device 220 according to a control signal from the control device 210. Qubits in the qubit device 220 are operated according to such generated high-frequency signals.

A user who uses the quantum computing system 300 generates, for example, a quantum circuit for solving a problem to be solved through quantum computation using the terminal device 30. When the user instructs the terminal device 30 to perform the quantum computation, a quantum computation request including the generated quantum circuit is transmitted from the terminal device 30 to the quantum computing system 300.

In the quantum computing system 300, the classical computer 100 causes the quantum computer 200 to perform quantum computation based on the quantum circuit in response to the quantum computation request. At this time, the classical computer 100 converts the quantum circuit to be executed into a quantum circuit including executable quantum gates, based on the hardware specifications of the quantum computer 200 (such as native gates supported by the qubit device). The classical computer 100 transmits, to the quantum computer 200, a quantum circuit execution instruction including information such as the operation timing of the quantum gates in the converted quantum circuit and the intensities of microwaves for the operations. The quantum computer 200 performs gate operations on qubits and measures the states of the qubits according to the quantum circuit execution instruction. Then, the quantum computer 200 transmits the measurement result to the classical computer 100.

The above system achieves quantum computation using qubits. Since the states of physical qubits are fragile, encoded logical qubits are used for quantum computation.

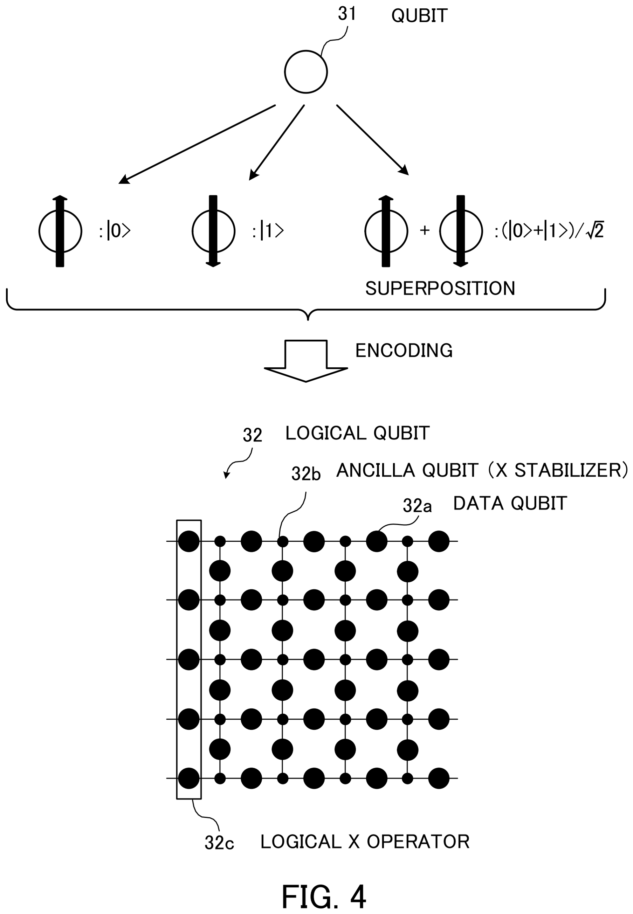

FIG. 4 illustrates an example of qubit encoding. In quantum computation, a qubit 31 corresponds to a bit in classical computation. The qubit 31 is able to take a superposition state of "$(|0\rangle + |1\rangle)/2^{1/2}$" in addition to the states of "$|0\rangle$" and "$|1\rangle$".

The qubit 31 is very fragile. Therefore, in the quantum computer 200, encoding is performed in which a plurality of physical qubits are combined into a single logical qubit 32. Here, a typical error-correcting code is a surface code. In a surface code, the state of the logical qubit 32 is represented by a plurality of data qubits 32a. In addition, a plurality of ancilla qubits 32b are provided for error detection.

A bit string of data qubits at one end of the logical qubit 32 constitutes a logical X operator 32c. The measurement value obtained by performing a projection measurement on the logical qubit 32 is determined based on the states of the data qubits constituting the logical X operator 32c.

Although FIG. 4 illustrates a plurality of ancilla qubits 32b for X stabilizers, a plurality of ancilla qubits for Z stabilizers, not illustrated, are also provided. The logical qubit 32 also includes a bit string of data qubits constituting a logical Z operator. The following mainly describes a quantum error correction technique for a logical X operator using the plurality of ancilla qubits 32b for X stabilizers. However, the same technique is similarly applicable to quantum error correction for a logical Z operator using a plurality of ancilla qubits for Z stabilizers.

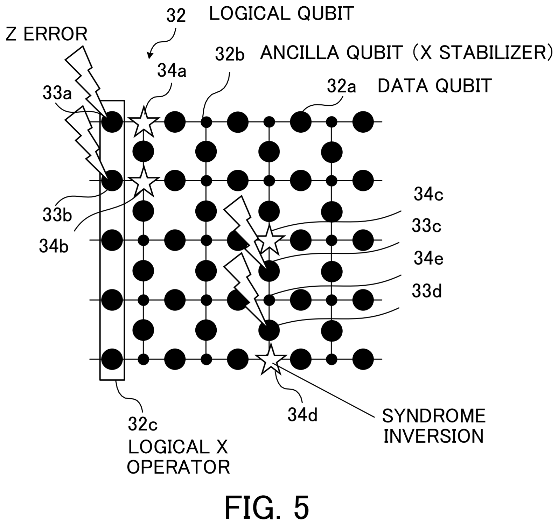

FIG. 5 illustrates an example of errors occurring in a logical qubit. There is a possibility that errors occur in the physical qubits constituting the logical qubit 32. An error occurring in any of the plurality of data qubits 32a is detectable based on the ancilla qubits adjacent to the data qubit in which the error has occurred.

The measurement value of each ancilla qubit obtained through the syndrome measurement is inverted from "+1" to "-1" if, among its adjacent data qubits, the number of data qubits in which errors have occurred is odd. On the other hand, the measurement value of each ancilla qubit obtained through the syndrome measurement is not inverted if, among its adjacent data qubits, the number of data qubits in which errors have occurred is even.

Referring to the example of FIG. 5, a Z error occurs in each data qubit 33a to 33d. As results of performing the syndrome measurement on ancilla qubits 34a to 34d adjacent to the data qubits 33a to 33d in which the Z errors have occurred, inverted measurement values are obtained. Since an ancilla qubit 34e is adjacent to the two data qubits 33c and 33d in which the errors have occurred, the measurement value of the ancilla qubit 34e obtained through the syndrome measurement is not inverted.

The quantum error correction involves estimating in which data qubit an error has occurred, based on the measurement values of the ancilla qubits obtained through the syndrome measurement. A function of identifying error locations on the basis of measurement values obtained through the syndrome measurement in a code such as a surface code is referred to as a decoder. For example, a decode graph is used for the estimation of error locations by the decoder.

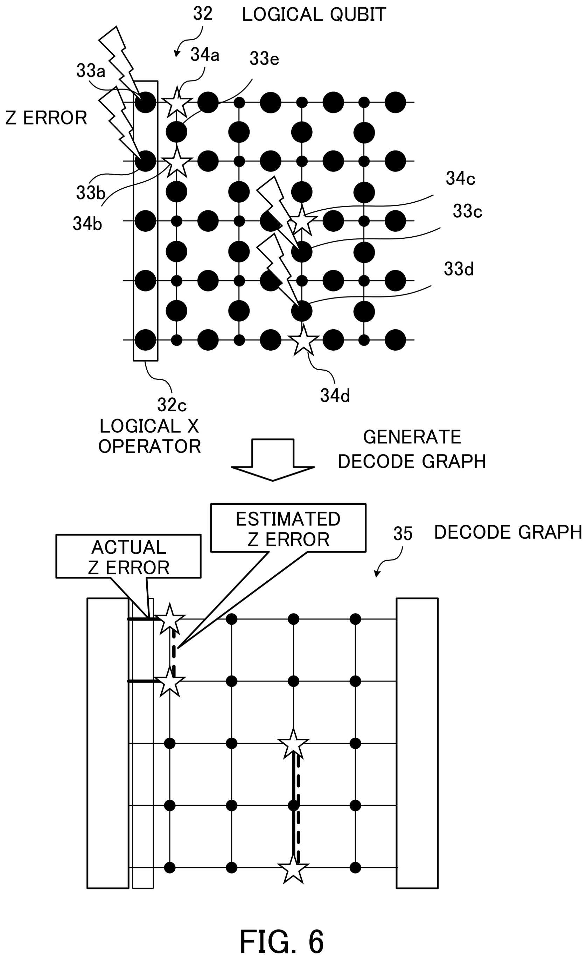

FIG. 6 illustrates an example of an error location estimation process using a decode graph. For example, a decode graph 35 is generated based on the measurement results, obtained through the syndrome measurement, of a plurality of ancilla qubits (for X stabilizers) that constitute the logical qubit 32.

The decode graph 35 is a graph in which the syndrome measurement result of each ancilla qubit is set as a vertex (node) and ancilla qubits that share the same adjacent data qubit are connected by an edge. In the quantum error correction, the syndrome measurement is repeatedly performed a plurality of times so that errors occurring in the syndrome measurement are also detected. Then, error locations are estimated based on the results obtained by performing the syndrome measurement a plurality of times.

In the case where the syndrome measurement is performed on a specific ancilla qubit a plurality of times, each syndrome measurement result is represented as the difference (exclusive OR) from the immediately preceding syndrome measurement result. A syndrome measurement result represented as such a difference is called a difference syndrome. In the first syndrome measurement, if an inverted measurement value is obtained, the difference syndrome measurement result is inverted. In the second and subsequent syndrome measurements, if a measurement value different from the previous measurement value is obtained, the different syndrome measurement result is inverted.

In the decode graph 35, a flag (indicated by a star in FIG. 6) indicating that the measurement value is inverted is set on each vertex corresponding to the ancilla qubits 34a to 34d whose difference syndrome has an inverted measurement value.

The decoder for the surface code obtains an error pattern of the data qubits that inverts the ancilla qubits 34a to 34d, whose syndrome measurement values are inverted, in the decode graph 35. A plurality of error patterns may be generated. In the example of FIG. 6, an error pattern indicating that errors have occurred in the data qubits 33a to 33d and an error pattern indicating that errors have occurred in the data qubits 33c to 33e are generated.

There is a possibility that the decoder estimates an error pattern (Z error occurrence in the data qubits 33c to 33e) that is different from an actual error pattern (Z error occurrence in the data qubits 33a to 33d). In the estimated error pattern (Z error occurrence in the data qubits 33c to 33e), the number of data qubits in which errors have occurred in the logical X operator 32c is "0". In actual, however, Z errors have occurred in two data qubits 33a and 33b in the logical X operator 32c.

As described above, an estimation result of error locations may be erroneous. However, if there is no difference in whether the number of errors in the logical X operator 32c is even or odd, a logical error does not occur. In the example of FIG. 6, the estimated number of errors in the logical X operator 32c is "0" (even number), whereas the actual number of errors is "2" (even number). In this case, since both the actual number of errors and the estimated number of errors are even, no logical error occurs.

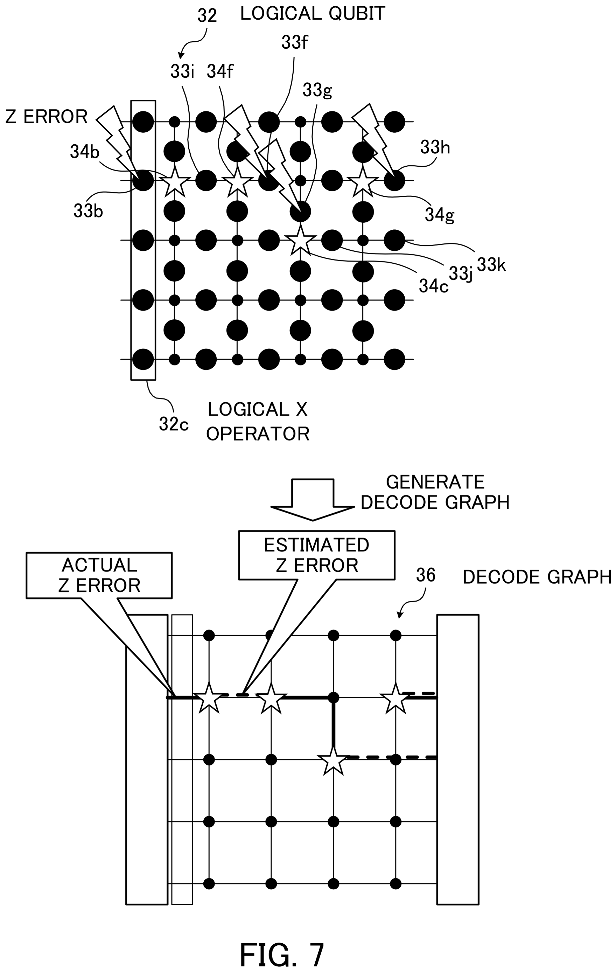

FIG. 7 illustrates an example of an error location estimation process that causes a logical error. In the example of FIG. 7, Z errors have occurred in data qubits 33b and 33f to 33h. In this case, the measurement values of ancilla qubits 34b, 34c, 34f, and 34g obtained through the syndrome measurement are inverted. Then, a decode graph 36 corresponding to the syndrome measurement results is generated.

If error locations are estimated based on the decode graph 36, for example, it may be estimated that Z errors have occurred in data qubits 33h and 33i to 33k. In this case, although the actual number of errors in the logical X operator 32c is "1" (odd number), the estimated number of errors is "0" (even number). As a result, a logic error occurs in the logical qubit 32.

Considering the above, it may be sufficient for the decoder to be able to finally estimate whether the number of errors in a logical operator is even or odd. Since the quantum data correction is repeatedly performed during the quantum computation, it is desired that the decoding is performed within a short time, for example, within about 1 µs.

As described above with reference to FIGS. 6 and 7, it is possible to estimate error locations in data qubits using a decode graph. At this time, it is important to reduce the likelihood of causing a logical error due to the difference between estimated error locations and actual error locations. To this end, for example, an algorithm for estimating an error pattern by calculating minimum-weight perfect matching (MWPM) between syndromes has been considered. This algorithm is called an MWPM decoder.

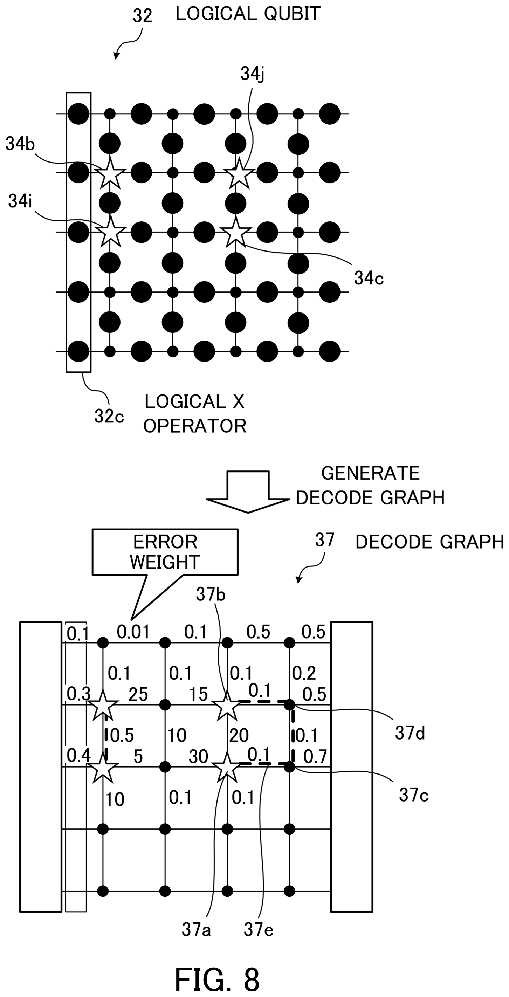

FIG. 8 illustrates an example of error pattern estimation by the MWPM decoder. In the example of FIG. 8, as a result of performing the syndrome measurement on the logical qubit 32, inverted measurement values are detected with respect to the ancilla qubits 34b, 34c, 34i, and 34j. A decode graph 37 is then generated based on the syndrome measurement result.

In the MWPM, an error weight is set for each edge connected to the vertices in the decode graph 37. An error weight for an edge is calculated based on a physical error rate $p_e$ of the data qubit corresponding to the edge. For example, the error weight $w_e$ is calculated by the following equation.

$$w_e = \log \frac{1 - p_e}{p_e} \qquad (1)$$

The error weight $w_e$ calculated by Equation (1) has a smaller value as the value of the physical error rate $p_e$ is larger. In the MWPM, for example, an error pattern is identified based on the decode graph 37 from among the error patterns indicating possible errors. This error pattern is the one in which the sum of the error weights of the edges corresponding to the data qubits in which errors have occurred is the smallest. Then, it is estimated that the errors indicated in the identified error pattern have occurred.

In the example of FIG. 8, the weight of the edge connecting the vertices 37a and 37b corresponding to the inverted ancilla qubits 34c and 34j is "20". On the other hand, the weight of the edge connecting the vertex 37a and the vertex 37c is "0.1", the weight of the edge connecting the vertex 37c and the vertex 37d is "0.1", and the weight of the edge connecting the vertex 37d and the vertex 37b is "0.1". Then, the sum of the weights of the edges included in a path 37e (broken line) from the vertex 37a to the vertex 37b via the vertex 37c and the vertex 37d is "0.3". Therefore, the total weight of the path 37e is smaller. Therefore, it is estimated that errors have occurred in the data qubits corresponding to the edges included in the path 37e.

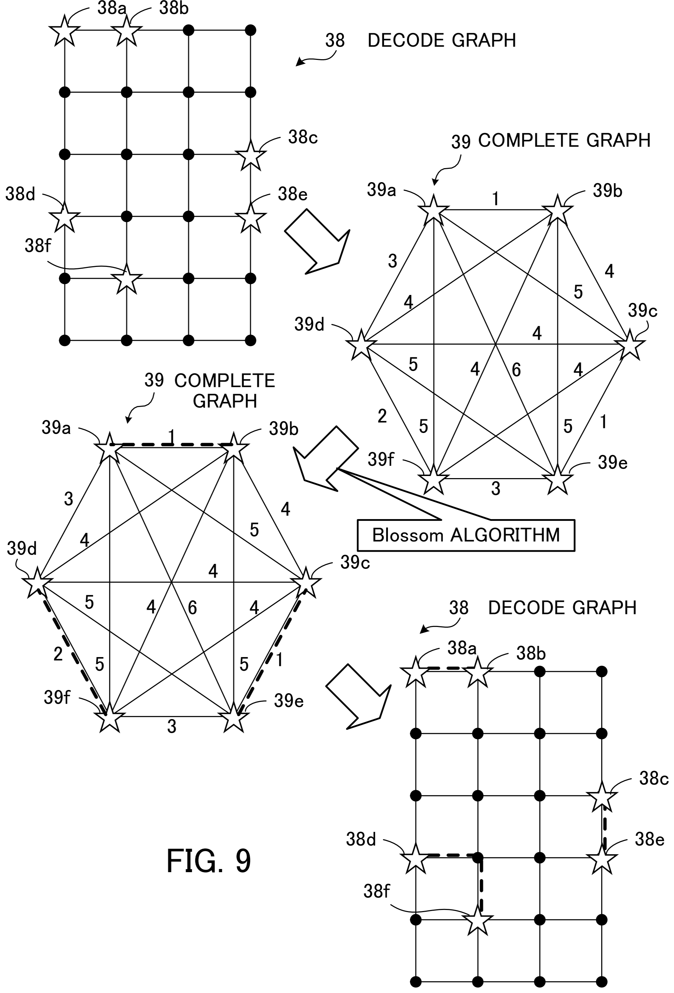

FIG. 9 illustrates an example of a processing procedure performed by the MWPM decoder. For example, it is assumed that the difference syndromes corresponding to six vertices 38a to 38f of a decode graph 38 are inverted. The Dijkstra's algorithm is executed on all combinations of the inverted difference syndromes, thereby generating a complete graph 39.

The complete graph 39 has vertices 39a to 39f respectively corresponding to the inverted difference syndromes. Every vertex 39a to 39f is connected to every other vertex by an edge. An error weight is set for each edge in the complete graph 39.

For example, the error weight of an edge in the complete graph 39 is the sum of the error weights of the edges included in a connection path on the decode graph 38, the connection path connecting the difference syndromes corresponding to the vertices at both ends of the edge. In the example of FIG. 9, an error weight is set for each edge in the complete graph 39 on the assumption that an error weight of "1" is set for each edge in the decode graph 38 for simplicity.

Based on the complete graph 39, an error pattern is estimated by the MWPM. The MWPM is executed by, for example, a Blossom algorithm. For example, it is estimated that an error has occurred in each of the data qubit corresponding to the edge connecting the vertices 39a and 39b, the data qubit corresponding to the edge connecting the vertices 39c and 39e, and the data qubit corresponding to the edge connecting the vertices 39d and 39f.

The complete graph 39 in which information on the error locations is set is returned to the decode graph 38. More specifically, in the decode graph 38 after the execution of the MWPM, the information (dotted lines in FIG. 9) indicating error locations is added to the edges corresponding to the error locations.

The algorithm for the above MWPM decoder involves calculating weights for all edges of the complete graph 39, which has high computational complexity. To avoid this, it is conceivable to estimate error locations without using the complete graph 39. For example, there is a method of expanding clusters each centered on a difference syndrome.

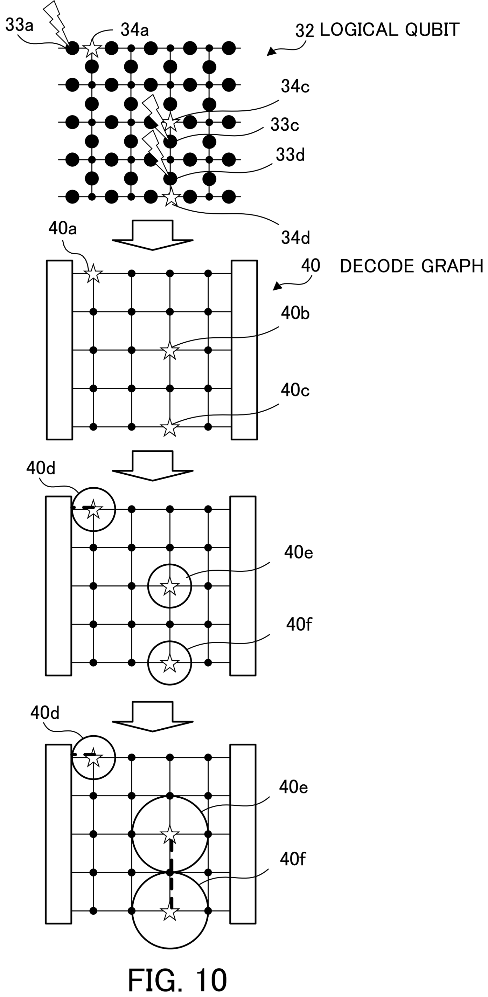

FIG. 10 illustrates an example of a method of expanding clusters. For example, it is assumed that Z errors have occurred in three data qubits 33a, 33c, and 33d. In this case, difference syndromes in which the measurement values of the ancilla qubits 34a, 34c, and 34d are inverted are obtained. A decode graph 40 is generated from the syndrome measurement results. Then, clusters 40d to 40f centered respectively on the vertices 40a to 40c corresponding to the inverted difference syndromes are generated in the decode graph 40. The initial states of the clusters 40d to 40f are circles, each having a corresponding one of the vertices 40a to 40c as its center and having a radius equal to half the length of the edges.

Among the generated clusters 40d to 40f, the cluster 40d reaches a region indicating a logical X operator. In this case, it is estimated that an error has occurred in the data qubits constituting the logical X operator, and the expansion of the cluster 40d is stopped.

The clusters 40e and 40f are gradually expanded. Then, the clusters 40e and 40f come into contact with each other. Then, it is estimated that errors have occurred in the data qubits corresponding to two edges connecting the clusters 40e and 40f. The employment of the method of expanding the clusters 40d to 40f in this manner eliminates the need to use the complete graph 39 as illustrated in FIG. 9.

Note, however, that the method of expanding the clusters 40d to 40f needs to store information indicating which edges are included in each cluster and from which difference syndrome each cluster is derived. In the case where the degree of the graph (the number of edges connected to a vertex) is "12", the amount of memory used is approximately equal to the capacity needed for storing "$12d^3$" records indicating information to be stored, where d denotes a code distance.

In order to repeatedly perform the decoding within a short time of 1 $\mu$s or less, it is preferable to minimize the amount of data to be referred to. Therefore, an algorithm that refers to a large amount of data is not suitable. In addition, in order to repeatedly perform the decoding during quantum computation, it is efficient to perform the decoding by a device located near the qubit device 220, such as the control device 210 of the quantum computer 200, using a logic circuit such as an FPGA or an ASIC. However, it is not realistic to mount a large-scale memory in the logic circuit.

In order to precisely execute such a method of expanding clusters, the memory capacity may be insufficient. To deal with this, it is conceivable to calculate the distance between difference syndromes using the Manhattan distance including hook errors, without storing values on edges (see, Ben Barber, et al., "A real-time, scalable, fast and highly resource efficient decoder for a quantum computer", arXiv: 2309.05558v2, quant-ph, 24-September-2024, mentioned earlier). This method, however, may fail to achieve sufficient performance in an actual machine environment deviating from an error model.

There is another method in which error locations are estimated by a decoder (Ising decoder) using an Ising model.

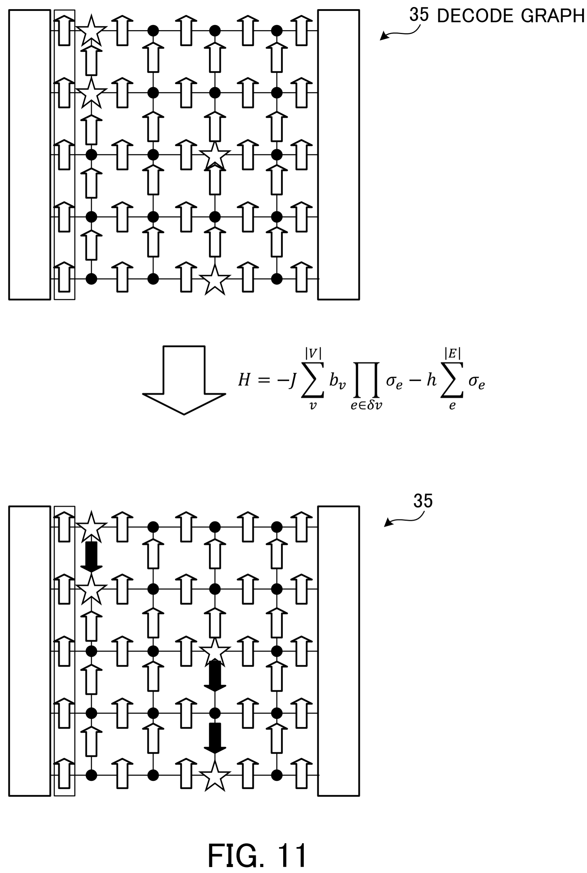

FIG. 11 illustrates an example of decoding using an Ising model. For example, as in the logical qubit 32 illustrated in FIG. 6, it is assumed that Z errors have occurred in the four data qubits 33a to 33d and the decode graph 35 is generated. In this case, a spin of the Ising model (an arrow on an edge in FIG. 11) is associated with each edge in the decode graph 35.

Then, an Ising model for obtaining a Hamiltonian H as represented by Equation (2) is defined.

$$H = -J \sum_{v}^{|V|} b_v \prod_{e \in \delta v} \sigma_e - h \sum_{e}^{|E|} \sigma_e \qquad (2)$$

V denotes the total number of difference syndromes. $b_v$ denotes whether the v-th difference syndrome is inverted or not ("+1" if not inverted, and "-1" if inverted). $\sigma_e$ is the value of the spin of the e-th edge. For example, $\sigma_e$ is "+1" if no error has occurred in the data qubit corresponding to the corresponding edge, and is "-1" if an error has occurred. E denotes the number of edges (equal to the number of data qubits). $\delta v$ denotes an edge connected to the v-th difference syndrome. J and h are predetermined coefficients (positive real numbers).

An Ising solver is used to obtain the values of the spins of the edges that minimize the cost function represented on the right-hand side of Equation (2). When the values of the spins that minimize the value of the cost function are obtained, it is estimated that an error has occurred in the data qubit corresponding to an edge in which the value of the spin is "-1".

As described above, the Ising decoder is usable to estimate error locations on the basis of the decode graph 35. The Ising decoder, however, gives the value of a spin to every edge, which needs a large-capacity memory as in the method of expanding clusters.

As described earlier, it is effective to implement the decoding function for estimating error locations on an FPGA or an ASIC. For this approach, however, it is needed to reduce the amount of memory to be used. To deal with this, the quantum computing system 300 assigns an address to each region of a decode graph, and at the time of decoding, generates a simplified decode graph in which only the difference syndromes with close addresses are connected to each other. The decoding using the simplified decode graph needs a small memory capacity. As a result, for example, such a decoding function may be implemented in the control device 210. The following describes how to implement the decoding using a simplified decode graph, with reference to an example in which the decoding function is implemented in the control device 210.

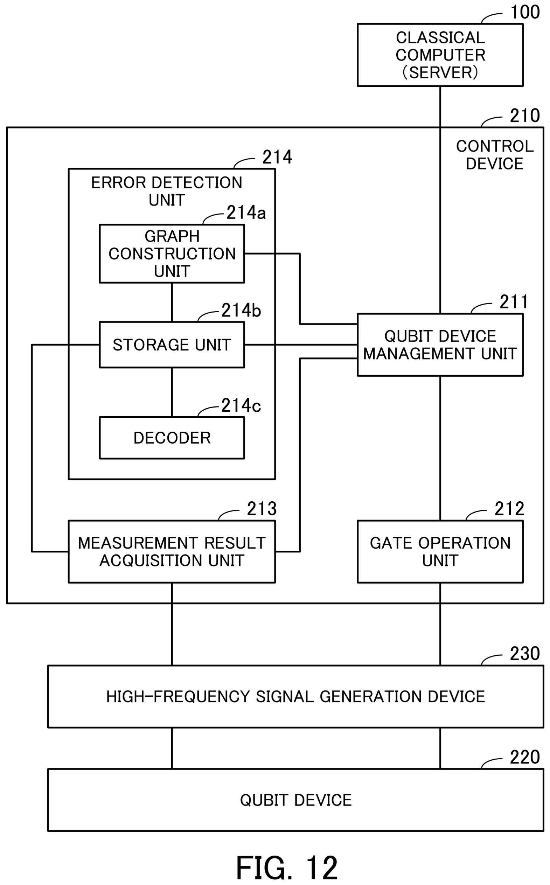

FIG. 12 is a block diagram illustrating an example of a quantum computation function that involves decoding using a simplified decode graph. For example, the control device 210 includes a qubit device management unit 211, a gate operation unit 212, a measurement result acquisition unit 213, and an error detection unit 214.

The qubit device management unit 211 manages the states of the physical qubits in the qubit device 220. For example, the qubit device management unit 211 manages the timing of performing gate operations on the physical qubits, manages the timing of measuring the states of the physical qubits, records measurement results, and so on.

For example, the qubit device management unit 211 receives, from the classical computer 100, a gate operation request generated based on a quantum circuit corresponding to a problem to be solved. The gate operation request includes physical qubits to be used, an encoding method, a code distance, the contents of gate operations, parameters for the gate operations, and others. The parameters for the gate operations include the intensities of microwaves, the timing of performing the syndrome measurement, the number of repetitions of the syndrome measurement, and others. The qubit device management unit 211 instructs the gate operation unit 212 to perform gate operations or measure the physical qubits according to the acquired information.

In addition, the qubit device management unit 211 acquires, from the measurement result acquisition unit 213, a measurement result when all gate operations and measurement of the quantum circuit are completed. The qubit device management unit 211 acquires information on errors that have occurred in the computation from the error detection unit 214, and corrects the measurement result based on the information on the errors. For example, in the case where the error information indicates the occurrence of a logical error in the logical X operator, the qubit device management unit 211 corrects the state of the logical X operator obtained from the measurement result to obtain a final measurement result. The qubit device management unit 211 then transmits the measurement result corrected based on the error information, to the classical computer 100.

The gate operation unit 212 controls the high-frequency signal generation device 230 according to the quantum circuit input from the classical computer 100, to perform gate operations or measurement operations on the qubit device 220. In addition, between the gate operations based on the quantum circuit corresponding to the problem to be solved, the gate operation unit 212 controls the high-frequency signal generation device 230, to perform gate operations or measurements for the syndrome measurement.

When the measurement operation on the physical qubits is performed, the measurement result acquisition unit 213 acquires the measurement result from the high-frequency signal generation device 230. When acquiring a measurement result of the measurement indicated in the quantum circuit corresponding to the problem to be solved, the measurement result acquisition unit 213 transmits the measurement result to the qubit device management unit 211. When the measurement result acquisition unit 213 acquires a measurement result of the syndrome measurement, the measurement result acquisition unit 213 transmits the measurement result to the error detection unit 214.

The error detection unit 214 detects an error in the logical qubit on the basis of the measurement result of the syndrome measurement. The error detection unit 214 includes a graph construction unit 214a, a storage unit 214b, and a decoder 214c.

The graph construction unit 214a constructs a simplified decode graph. For example, the graph construction unit 214a divides an unsimplified decode graph into a plurality of regions. Then, the graph construction unit 214a generates a decode graph that includes edges each connecting vertices corresponding to inverted difference syndromes in two regions within a predetermined distance of each other, and vertices connected by the edges.

After the syndrome measurement is performed, the graph construction unit 214a acquires the measurement result from the storage unit 214b. After that, the graph construction unit 214a generates a decode graph, which is a simplification of a decode graph generated in advance, based on the measurement result of the syndrome measurement.

The storage unit 214b stores address information indicating the positions of regions obtained by dividing the decode graph, the presence or absence of inversion of difference syndromes, the connection relationships between the difference syndromes, a decoding result, and others. In addition, the storage unit 214b stores the decode graph before simplification (including information on subregions and the addresses thereof) and the decode graph after simplification.

The decoder 214c estimates error locations using the simplified decode graph based on syndrome measurement result. Then, the decoder 214c determines whether a logical error has occurred in each of a plurality of logical qubits, based on the estimated error locations. The decoder 214c stores information on the presence or absence of an error in each logical qubit in the storage unit 214b.

As described above, the control device 210 controls the qubit device 220 so that the qubit device 220 performs quantum computation according to a quantum circuit while detecting errors in logical qubits. Hereinafter, a processing procedure performed in the control device 210 will be described.

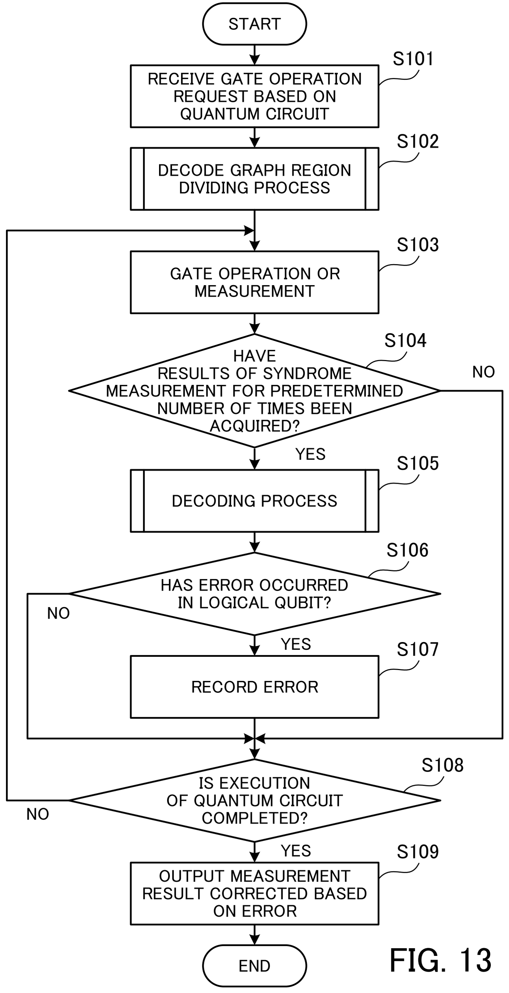

FIG. 13 illustrates an example procedure for computation based on a quantum circuit. Hereinafter, the process illustrated in FIG. 13 will be described in order of step numbers.

[Step S101] The qubit device management unit 211 receives, from the classical computer 100, a gate operation request generated based on a quantum circuit corresponding to a problem to be solved.

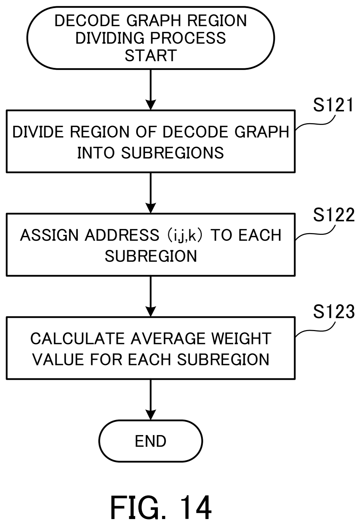

[Step S102] The error detection unit 214 performs a decode graph region dividing process. Details of the decode graph region dividing process will be described later (see FIG. 14).

[Step S103] The qubit device management unit 211 determines a gate operation or measurement to be performed next, and instructs the gate operation unit 212 to perform the gate operation or measurement. In response to the instruction, the gate operation unit 212 performs the gate operation or the measurement operation on the specified physical qubits. The gate operation or measurement at this time includes a gate operation or measurement indicated in the quantum circuit corresponding to the problem to be solved, and a gate operation or measurement for the syndrome measurement.

When the measurement operation is performed, the measurement result is acquired by the measurement result acquisition unit 213. When acquiring the measurement result of the measurement indicated in the quantum circuit to be solved, the measurement result acquisition unit 213 transmits the measurement result to the qubit device management unit 211. When acquiring the measurement result of the syndrome measurement, the measurement result acquisition unit 213 stores the measurement result in the storage unit 214b of the error detection unit 214.

[Step S104] The graph construction unit 214a of the error detection unit 214 determines whether results of the syndrome measurement performed a predetermined number of times at the error detection timing have been acquired. If the graph construction unit 214a has acquired the results of the syndrome measurement for the predetermined number of times, the process proceeds to step S105. If the graph construction unit 214a has not acquired the results of the syndrome measurement for the predetermined number of times, the process proceeds to step S108.

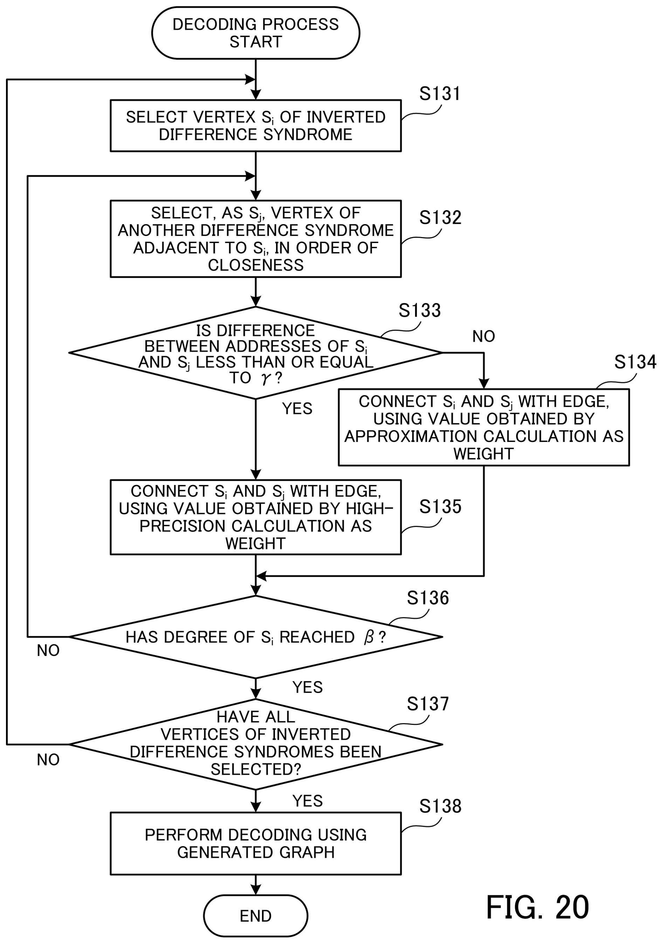

[Step S105] The error detection unit 214 performs the decoding process. Details of the decoding process will be described later (see FIG. 20).

[Step S106] The decoder 214c of the error detection unit 214 determines whether an error has occurred in a logical qubit. If an error has occurred, the decoder 214c advances the process to step S107. If no error has occurred, the decoder 214c advances the process to step S108.

[Step S107] The decoder 214c records the content of the error in the storage unit 214b. The content of the error is information such as which logical qubit has the error, the type of the error, and others. Examples of the error type include an inversion error of a logical X operator and an inversion error of a logical Z operator.

[Step S108] The qubit device management unit 211 determines whether the execution of the quantum circuit is completed. If the execution of the quantum circuit is completed, the qubit device management unit 211 advances the process to step S109. If the execution of the quantum circuit is not completed, the qubit device management unit 211 advances the process to step S103.

[Step S109] The qubit device management unit 211 outputs the measurement result corrected based on the error that has occurred, to the classical computer 100.

As described above, a gate operation according to the quantum circuit is performed, and the measurement result after the gate operation is corrected based on an error that has occurred. Next, the decode graph region dividing process will be described in detail.

FIG. 14 is a flowchart illustrating an example procedure for the decode graph region dividing process. Hereinafter, the process illustrated in FIG. 14 will be described in order of step numbers.

[Step S121] The graph construction unit 214a of the error detection unit 214 divides the region of the decode graph into subregions. For example, the graph construction unit 214a divides the three-dimensional space of the decode graph, represented by two axes of a plane indicating the arrangement of physical qubits constituting the logical qubits and an axis (time axis) indicating the number of syndrome measurements, along each axis.

[Step S122] The graph construction unit 214a assigns an address (i, j, k) to each subregion (i, j, and k are natural numbers). For example, the graph construction unit 214a represents the positions of subregions along the two axes of the plane indicating the arrangement of the physical qubits by "i" and "j", and represents the position of a subregion along the time axis by "k".

[Step S123] The graph construction unit 214a calculates an average weight value for each subregion. For example, the graph construction unit 214a identifies, for each subregion, edges connected to the vertices included in that subregion among the vertices of the decode graph. Then, the graph construction unit 214a calculates, for each subregion, the average of weights of the identified edges in the decode graph. The graph construction unit 214a sets the calculation result as the average weight value of the subregion.

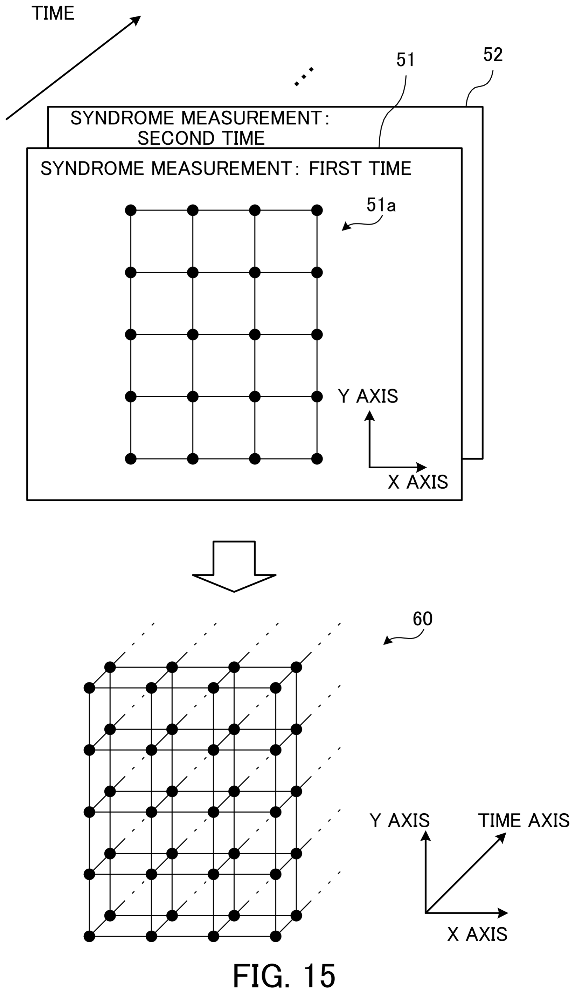

Hereinafter, the decode graph region dividing process will be specifically described with reference to FIGS. 15 to 19.

FIG. 15 illustrates an example of a three-dimensional decode graph. For example, each time a gate operation is performed on a logical qubit, the syndrome measurement is performed a plurality of times, and measurement results 51, 52, ... are obtained for the syndrome measurements. One measurement result 51 may be represented by a graph 51a that includes vertices indicating ancilla qubits measured and lines each connecting ancilla qubits connected to the same data qubit. For example, the graph 51a is represented by a plane defined by the X axis and the Y axis.

Measurement results 51, 52, ... obtained by performing the syndrome measurement a plurality of times are arranged along the elapsed time from the first execution of the syndrome measurement to the acquisition of each measurement result, so that the measurement results 51, 52, ... are positioned on the time axis. Among the vertices of the graphs representing the measurement results 51, 52, ..., vertices that are continuous in the time direction and correspond to the same ancilla qubit are connected by an edge, thereby forming a three-dimensional decode graph 60.

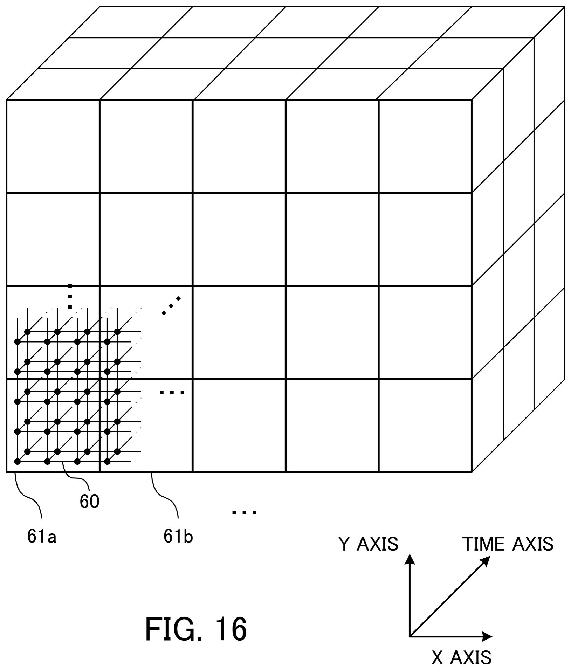

FIG. 16 illustrates an example of a process of dividing a decode graph. For example, the space where the decode graph 60 exists is divided along the three axes. This dividing generates a plurality of subregions 61a, 61b, ... in the form of rectangular parallelepipeds. In the example of FIG. 16, the space is divided into subregions 61a, 61b, ..., each of which is sized to include three vertices corresponding to ancilla qubits along each axis.

In the decode graph 60 illustrated in FIG. 16, only six edges at the maximum are connected to a single vertex. However, in the case where errors that may occur in syndrome measurements are taken into account, twelve edges at the maximum may be connected to a single vertex (the maximum degree is "12").

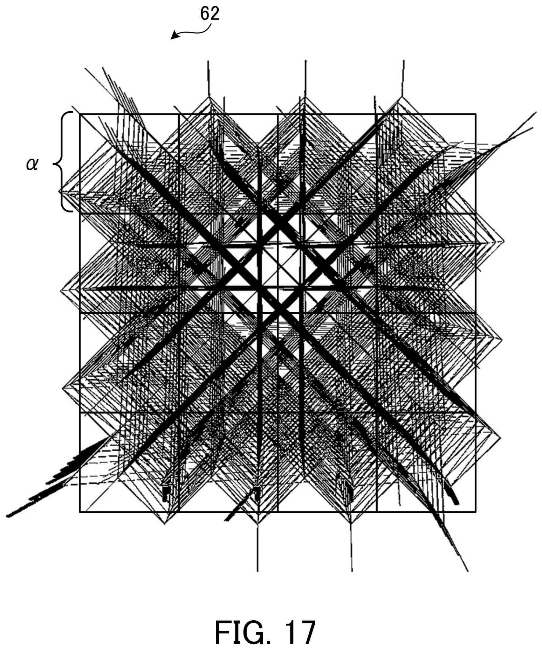

FIG. 17 illustrates an example of a divided decode graph. A decode graph 62 illustrated in FIG. 17 is divided into subregions, each of which includes $\alpha$ vertices along each spatial axis and the time axis. An address is assigned to each of thus divided subregions.

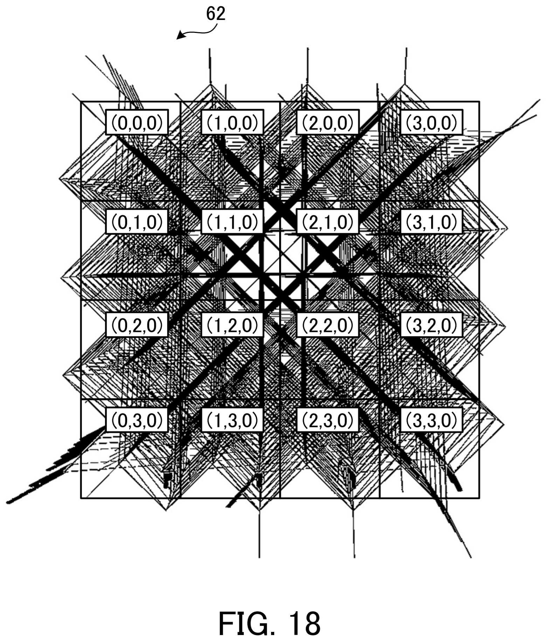

FIG. 18 illustrates an example of addresses assigned to subregions. FIG. 18 illustrates the addresses of the subregions located at the forefront in the time axis of the decode graph 62. Each address is represented as (i, j, k). Here, i represents a position along the horizontal axis (X-axis) of the space. j represents a position along the vertical axis (Y-axis) of the space. k indicates a position along the time axis. Furthermore, an average weight value is calculated for each subregion.

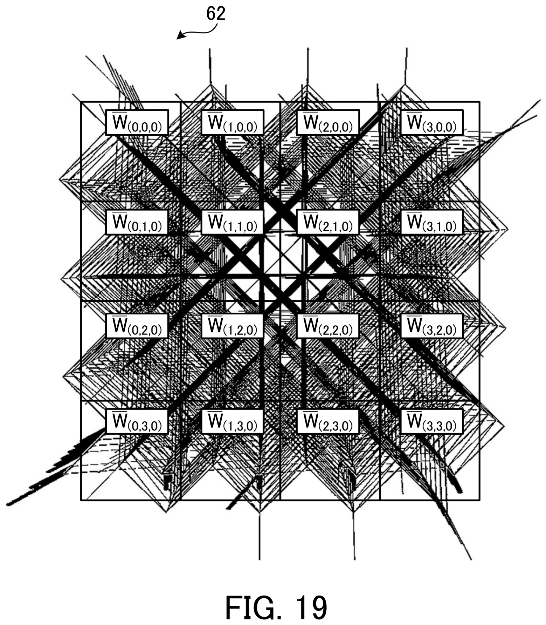

FIG. 19 illustrates an example of the average weight values of subregions. In FIG. 19, the average weight value of a subregion at address (i, j, k) is denoted by "$\overline{W}_{(i,j,k)}$" (W is overlined). The average weight value of a subregion is, for example, the average of the weights of the edges connected to the vertices included in the subregion.

After the syndrome measurement is performed, the decoding process is performed based on the decode graph 62 divided into the subregions, to determine whether an error has occurred in the logical qubit.

FIG. 20 is a flowchart illustrating an example procedure for the decoding process. Hereinafter, the process illustrated in FIG. 20 will be described in order of step numbers.

[Step S131] The graph construction unit 214a selects the vertex $S_i$ of an inverted difference syndrome.

[Step S132] The graph construction unit 214a selects, as $S_j$, one vertex of the inverted difference syndromes belonging to other subregions neighboring the subregion to which the vertex $S_i$ of the inverted difference syndrome belongs, in order of closeness. Such other neighboring subregions are, for example, those whose differences in address from the subregion are less than or equal to a predetermined value. The difference between the addresses is, for example, the Manhattan distance.

[Step S133] The graph construction unit 214a determines whether the difference between the addresses of the subregions to which the vertices $S_i$ and $S_j$ belong is less than or equal to $\gamma$, where $\gamma$ is an integer of 0 or greater. If the difference between the addresses is less than or equal to $\gamma$, the graph construction unit 214a advances the process to step S135. If the difference between the addresses exceeds $\gamma$, the graph construction unit 214a advances the process to step S134.

[Step S134] The graph construction unit 214a connects the vertex $S_i$ and the vertex $S_j$ with an edge, using the value obtained by approximation calculation as the weight. For example, the graph construction unit 214a calculates the weight, based on the average weight values of the subregions along the path from the subregion to which the vertex $S_i$ belongs to the subregion to which the vertex $S_j$ belongs. Specifically, the graph construction unit 214a further averages the average weight values of the subregions on this path, and multiplies the resulting average value by the Manhattan distance between the vertex $S_i$ and the vertex $S_j$. Thereafter, the graph construction unit 214a advances the process to step S136.

[Step S135] The graph construction unit 214a connects the vertex $S_i$ and the vertex $S_j$ with an edge, using the value obtained by high-precision calculation as the weight. For example, the graph construction unit 214a identifies a path in which the sum of the weights of the edges connecting the vertex $S_i$ and the vertex $S_j$ is minimized in the decode graph before simplification, for example, by the A* algorithm. Then, the graph construction unit 214a sets the sum of the weights of the edges along the identified path as the weight of the edge connecting the vertex $S_i$ and the vertex $S_j$.

[Step S136] The graph construction unit 214a determines whether the degree of the vertex $S_i$ (i.e., the number of edges connected to the vertex $S_i$) has reached $\beta$, where $\beta$ is a natural number indicating the maximum degree of the simplified decode graph. If the degree has reached $\beta$, the graph construction unit 214a advances the process to step S137. If the degree has not reached $\beta$, the graph construction unit 214a advances the process to step S132.

The upper limit value $\beta$ of the degree, which is determined in advance, prevents the generation of vertices with a degree exceeding $\beta$, so that the simplified decode graph does not become overly complicated.

[Step S137] The graph construction unit 214a determines whether all vertices of the inverted difference syndromes have been selected. If all the vertices have been selected, the graph construction unit 214a advances the process to step S138. If any vertex remains unselected, the graph construction unit 214a advances the process to step S131.

[Step S138] The decoder 214c performs the decoding using the graph (simplified decode graph) generated by steps S131 to S137, and determines whether a logical error has occurred.

In this way, it is possible to perform the decoding using the simplified decode graph and to determine the presence or absence of a logical error. Since the decode graph is simplified, it is possible to perform the decoding within a short time.

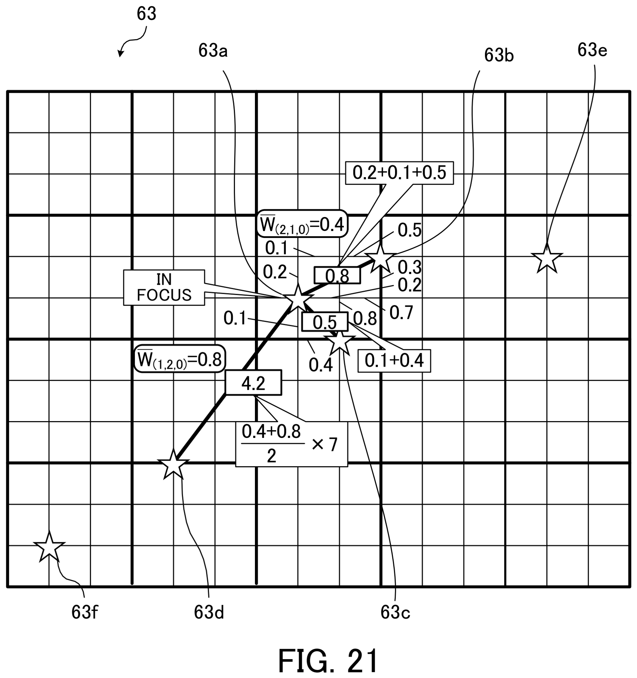

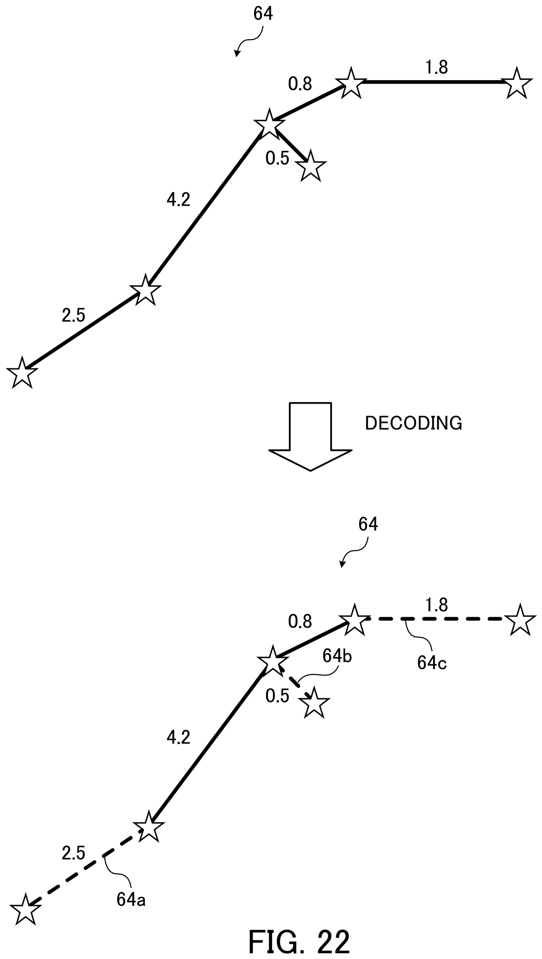

Hereinafter, the decoding process using a simplified decode graph will be specifically described with reference to FIGS. 21 and 22.

FIG. 21 illustrates an example of a simplified decode graph. Among the ancilla qubits corresponding to the vertices (lattice points) of an unsimplified decode graph 63, the ancilla qubits corresponding to vertices 63a to 63f, indicated by stars, are measured, thereby obtaining inverted difference syndromes. The decode graph 63 is divided into a plurality of subregions, with heavy-line rectangles as boundary lines. In this example, each vertex on a boundary line is considered to belong to both subregions in contact with each other at the boundary line.

Here, attention is focused on the vertex 63a corresponding to an inverted difference syndrome. The vertex 63a belongs to the subregion at address (2, 1, 0). In this example, the difference syndromes belonging to the eight subregions surrounding the subregion to which the focused vertex 63a belongs are the calculation targets for the distances between the vertices of the difference syndromes. In the example of FIG. 21, the vertices 63b to 63d are distance calculation targets, whereas the vertices 63e to 63f are not distance calculation targets.

Among the distance calculation targets, the vertices 63b to 63c belong to the same subregion at address (2, 1, 0) as the focused vertex 63a. Therefore, high-precision distance calculation is performed for the distances between the focused vertex 63a and each of the vertices 63b to 63c. A high-precision distance calculation method is an A* algorithm or another.

For example, in one of the paths along which edges are traced from the vertex 63a to the vertex 63b, the weights of the edges are "0.2", "0.1", and "0.5", respectively. The sum of the weights of the edges along this path is "0.8". In another path along which edges are traced from the vertex 63a to the vertex 63b, the weights of the edges are "0.2", "0.7", and "0.3", respectively. The sum of the weights of the edges along this path is "1.2". The minimum sum of the weights is "0.8", so that the distance between the vertex 63a and the vertex 63b is converted into "0.8".

Similarity, in one of the paths along which edges are traced from the vertex 63a to the vertex 63c, the weights of the edges are "0.1" and "0.4", respectively. The sum of the weights of the edges along this path is "0.5". In another path along which edges are traced from the vertex 63a to the vertex 63c, the weights of the edges are "0.2" and "0.8", respectively. The sum of the weights of the edges along this path is "1.0". The minimum sum of the weights is "0.5", so that the distance between the vertex 63a and the vertex 63c is converted into "0.5".

Among the distance calculation targets, the vertex 63d belongs to a subregion at address (1, 2, 0) different from that of the focused vertex 63a. Therefore, the distance between the focused vertex 63a and vertex 63d is calculated using a high-speed approximation method.

In the example of FIG. 21, the average weight value of the subregion to which the focused vertex 63a belongs is "0.4". The average weight value of the subregion to which the vertex 63d belongs is "0.8". The Manhattan distance between the vertex 63a and the vertex 63d on the decode graph 63 is "7". In this case, the distance between the vertex 63a and the vertex 63d is calculated as "$\{(0.4 + 0.8)/2\} \times 7 = 4.2$". The use of this approximation method in this way simplifies the distance calculation for vertices belonging to neighboring subregions.

Vertices between which the distance has been calculated are connected by an edge. A weighted distance between the vertices connected by the edge is set for the edge. By sequentially focusing on each of the vertices 63b to 63f other than the vertex 63a and performing the distance calculation and the edge connection, a simplified decode graph is generated. Then, the decoding process is performed using the simplified decode graph.

FIG. 22 illustrates an example of the decoding process using a simplified decode graph. In a simplified decode graph 64, vertices between which the distance has been calculated are connected by an edge. For each edge, the distance obtained by a distance calculation is set as a weight for that edge. The accuracy of the edge weights depends on the distance calculation method (high-precision distance calculation or approximation calculation). As a weight for an edge connecting vertices far apart, the average weight values of their subregions are used. Therefore, the weight is reduced to an average error model. As a weight for an edge connecting vertices close to each other, the weights of the edges in the decode graph 63 before simplification are used, so that an accurate minimum value is set.

The decoding is performed using the simplified decode graph 64. For the decoding, for example, a method using Ising data, a method using MWPM, or the like may be used. In the example of FIG. 22, the combination of the edges 64a to 64c has the minimum total weight among the combinations of the edges corresponding to the inverted difference syndromes. Therefore, as a result of the decoding, it is determined that errors have occurred in the data qubits corresponding to the edges 64a to 64c indicated by broken lines.

During the decoding, the decoder 214c may add edges passing through data qubits constituting a logical operator to at least one vertex of the simplified decode graph 64, for example. In the case where logical X operators are present on the left and right sides and a logical X error is to be detected, edges may be added to the leftmost and rightmost vertices, for example. Furthermore, the decoder 214c may add edges that are connected to data qubits constituting logical operators, to vertices belonging to subregions at the left and right ends.

For example, the decoder 214c adds, to a vertex to which an edge is to be added, the edge that is connectable to any of the data qubits constituting a logical operator at the shortest distance. A weight for the edge is, for example, the sum of the weights of the edges corresponding to the edge in the decode graph before simplification. The addition of such an edge contributes to preventing decoding failure. Decoding failure is such that an error pattern corresponding to inverted difference syndromes is not found.

In addition, the addition of an edge connected to a data qubit constituting a logical operator increases the likelihood of correctly calculating the number of errors in the data qubits constituting the logical operator. As a result, the detection accuracy for logical errors is improved.

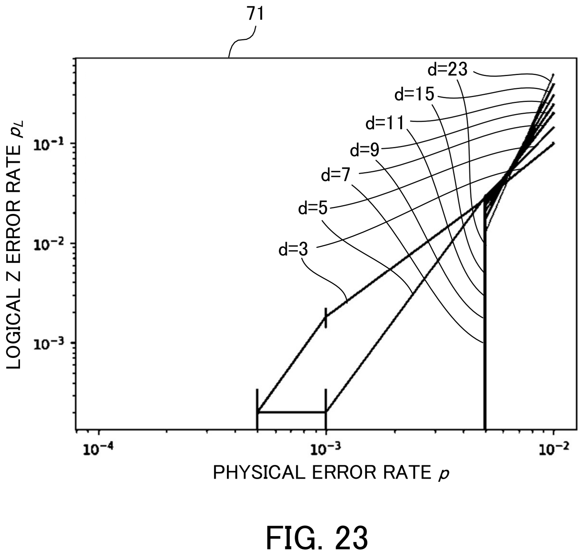

FIG. 23 illustrates an accuracy evaluation result obtained when decoding is performed by MWPM using a simplified decode graph. A graph 71 represents a logical error rate corresponding to a physical error rate for code distances of "3, 5, 7, 9, 11, 15, and 23". The horizontal axis of the graph 71 represents the physical error rate, and the vertical axis thereof represents the logical error rate.

As seen in the graph 71, in a situation where the physical error rate is less than or equal to a certain value, the logical error rate decreases as the code distance increases. That is, even using the simplified decode graph, the logic error rate is suppressed according to the code distance. This indicates that the decoder satisfies the performance requirement, which is that the decoding accuracy improves as the code distance increases.

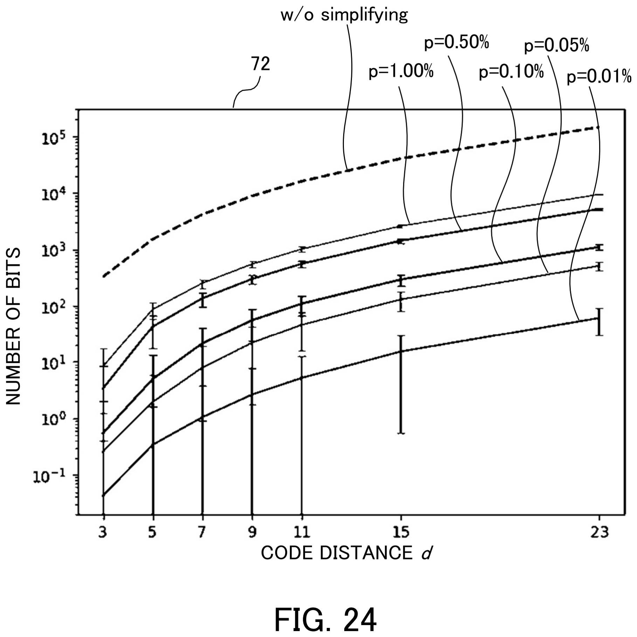

FIG. 24 illustrates an evaluation result of the amount of memory used when decoding is performed by an Ising decoder using a simplified decode graph. A graph 72 represents the amount of memory used for the physical error rates p of "0.01%, 0.05%, 0.10%, 0.50%, and 1.00%" and the amount of memory used for the case where an unsimplified decode graph is used (w/o simplifying). The horizontal axis of the graph 72 represents the code distance, and the vertical axis thereof represents the number of bits used for calculation.

The number of bits used when the unsimplified decode graph is used is "$12d^3$". The number of bits used when the simplified decode graph is used was determined experimentally.

As seen in the graph 72, the amount of memory used, represented by the number of bits, is greatly reduced by using the simplified decode graph. By reducing the amount of memory used, it becomes easy to implement the decoder on an FPGA or an ASIC, which results in reducing the time needed for the error location estimation process.

[Other Embodiments]

In the second embodiment, the decoding is performed by the control device 210 in the quantum computer 200. Alternatively, if the communication delay between the quantum computer 200 and the classical computer 100 is sufficiently small, the decoding may instead be performed by the classical computer 100.

The control device 210 may determine the value of $\beta$ indicating the maximum degree of vertices corresponding to inverted difference syndromes, based on the physical error rate of the qubit device 220. For example, the control device 210 determines the value of $\beta$ as follows.

[Step 1] The control device 210 decodes a decode graph as it is, without simplification, and calculates a logical error rate $P_{original}$.

[Step 2] The control device 210 sets $\beta$ to an initial value "1" ($\beta = 1$).

[Step 3] The control device 210 performs the decoding using the simplified decode graph and calculates a logical error rate $P_{simple(\beta)}$.

[Step 4] If $P_{original} = P_{simple(\beta)}$ is not satisfied, the control device 210 adds "1" to $\beta$ and advances the process to step 3.

[Step 5] If $P_{original} = P_{simple(\beta)}$ is satisfied in step 4, the control device 210 sets the current value of $\beta$ as the optimal $\beta$.

In this way, it is possible to appropriately determine the value of $\beta$ indicating the maximum degree of vertices corresponding to inverted difference syndromes. With an appropriate $\beta$, simplification of the decode graph reduces the amount of data to be used and the calculation time, while preventing a deterioration in the estimation accuracy of error locations.

Although the embodiments have been described above, the configuration of each unit described in the embodiments may be replaced with another unit having the same function. In addition, any other components or processes may be added. Furthermore, any two or more configurations (features) of the above-described embodiments may be combined.

According to one aspect, the time needed to estimate error locations in a logical qubit is reduced.

In any of the above aspects, the various features may be implemented in hardware, or as software modules running on one or more processors/computers.

The invention also provides a computer program or a computer program product comprising instructions which, when executed by a computer, cause the computer to carry out any of the methods/method steps described herein, and a non-transitory computer-readable medium comprising instructions which, when executed by a computer, cause the computer to carry out any of the methods/method steps described herein. A computer program embodying the invention may be stored on a non-transitory computer-readable medium, or it could, for example, be in the form of a signal such as a downloadable data signal provided from an Internet website, or it could be in any other form.

**Claims**

1. An information processing apparatus comprising:
   processing means (12) for:

   generating a first decode graph (3) including first vertices corresponding to a plurality of first qubits, respectively, and first edges each connecting the first vertices corresponding to two first qubits among the plurality of first qubits, the plurality of first qubits being used for detecting an error occurring in qubits in a qubit device (1), the two first qubits sharing a same qubit among the qubits as an error detection target, each of the first edges being assigned a first weight based on a probability of detecting an error with the first qubits corresponding to the first vertices at both ends of said each of the first edges;

   identifying, from among the plurality of first vertices, a pair of second vertices (4a to 4f) corresponding to two different second qubits among a plurality of second qubits in which errors have been detected through syndrome measurement, the second vertices of the pair having been determined to be at a short distance based on a first determination criterion as to whether a distance between the second vertices (4a to 4f) is long or short;

   determining a second weight for a second edge connecting the second vertices of the pair, based on the first weights of the first edges included in a path connecting the second vertices of the pair in the first decode graph (3);

   generating a second decode graph (7) including the second vertices of the pair and the second edge connecting the second vertices of the pair, the second edge being assigned the second weight; and

   estimating a third qubit in which an error has occurred, based on the second weight of the second edge in the second decode graph (7).

2. The information processing apparatus according to claim 1, wherein identifying of the pair includes

   dividing a region where the first decode graph (3) exists into a plurality of subregions (3a, 3b, ...), and
   determining, based on the first determination criterion related to a positional relationship between subregions to which two second vertices under determination belong, whether a distance between the two second vertices under determination is long or short.

3. The information processing apparatus according to claim 2, wherein determining of the second weight for the second edge includes determining a calculation method for calculating the second weight, according to whether a second determination criterion is satisfied, the second determination criterion being used for determining that a distance between subregions to which the second vertices of the pair belong is short.

4. The information processing apparatus according to claim 3, wherein the determining of the second weight for the second edge includes

determining the second weight using a first calculation method, upon determining that a positional relationship between the subregions to which the second vertices of the pair belong satisfies the second determination criterion, and
determining the second weight using a second calculation method, upon determining that the positional relationship does not satisfy the second determination criterion, the second calculation method being less precise than the first calculation method.

5. The information processing apparatus according to claim 4, wherein the determining of the second weight for the second edge includes

calculating, for each of the plurality of subregions in the first decode graph (3), an average weight of the first weights of the first edges in said each of the plurality of subregions, and
replacing, upon determining that the second determination criterion is not satisfied, the first weight of each of the first edges with the average weight of the subregion to which said each of the first edges belongs, and determining the second weight.

6. The information processing apparatus according to any of the preceding claims, wherein identifying of the pair includes preventing a number of pairs, each formed by each of the second vertices and a different second vertex, from exceeding a predetermined upper limit value.

7. A computer program that causes a computer to perform a process comprising:

generating a first decode graph (3) including first vertices corresponding to a plurality of first qubits, respectively, and first edges each connecting the first vertices corresponding to two first qubits among the plurality of first qubits, the plurality of first qubits being used for detecting an error occurring in qubits in a qubit device (1), the two first qubits sharing a same qubit among the qubits as an error detection target, each of the first edges being assigned a first weight based on a probability of detecting an error with the first qubits corresponding to the first vertices at both ends of said each of the first edges;
identifying, from among the plurality of first vertices, a pair of second vertices (4a to 4f) corresponding to two different second qubits among a plurality of second qubits in which errors have been detected through syndrome measurement, the second vertices of the pair having been determined to be at a short distance based on a first determination criterion as to whether a distance between the second vertices (4a to 4f) is long or short;
determining a second weight for a second edge connecting the second vertices of the pair, based on the first weights of the first edges included in a path connecting the second vertices of the pair in the first decode graph (3);
generating a second decode graph (7) including the second vertices of the pair and the second edge connecting the second vertices of the pair, the second edge being assigned the second weight; and
estimating a third qubit in which an error has occurred, based on the second weight of the second edge in the second decode graph (7).

8. An error estimation method executed by a computer, the error estimation method comprising:

generating a first decode graph (3) including first vertices corresponding to a plurality of first qubits, respectively, and first edges each connecting the first vertices corresponding to two first qubits among the plurality of first qubits, the plurality of first qubits being used for detecting an error occurring in qubits in a qubit device (1), the two first qubits sharing a same qubit among the qubits as an error detection target, each of the first edges being assigned a first weight based on a probability of detecting an error with the first qubits corresponding to the first vertices at both ends of said each of the first edges;

identifying, from among the plurality of first vertices, a pair of second vertices (4a to 4f) corresponding to two different second qubits among a plurality of second qubits in which errors have been detected through syndrome measurement, the second vertices of the pair having been determined to be at a short distance based on a first determination criterion as to whether a distance between the second vertices (4a to 4f) is long or short;

determining a second weight for a second edge connecting the second vertices of the pair, based on the first weights of the first edges included in a path connecting the second vertices of the pair in the first decode graph (3);

generating a second decode graph (7) including the second vertices of the pair and the second edge connecting the second vertices of the pair, the second edge being assigned the second weight; and

estimating a third qubit in which an error has occurred, based on the second weight of the second edge in the second decode graph (7).

FIG. 1

30 TERMINAL DEVICE

20

NETWORK

300

QUANTUM COMPUTING SYSTEM

200

100

QUANTUM COMPUTER

CLASSICAL COMPUTER

FIG. 2

21 MONITOR

100 CLASSICAL COMPUTER

104

101

PROCSSOR

GRAPHIC
CONTROLLER

22 KEYBOARD

105

102

MEMORY

INPUT
INTERFACE

23 MOUSE

103

STORAGE
DEVICE

106

OPTICAL
DRIVE DEVICE

24 OPTICAL
DISC

107

25 MEMORY
DEVICE

108

NETWORK
INTERFACE

DEVICE
CONNECTION
INTERFACE

109

100a
BUS

COMMUNI-
CATION
INTERFACE

26 MEMORY
READER/WRITER

27 MEMORY
CARD

NETWORK

200

QUANTUM
COMPUTER

210

CONTROL DEVICE

210a

ARITHMETIC
CIRCUIT

210b

20

MEMORY

230

HIGH-FREQUENCY
SIGNAL
GENERATION
DEVICE

220

QUBIT DEVICE

FIG. 3

31 QUBIT

:|0⟩     :|1⟩     +     :(|0⟩+|1⟩)/√2

SUPERPOSITION

ENCODING

32 LOGICAL QUBIT

32b ANCILLA QUBIT (X STABILIZER)

32a DATA QUBIT

32c LOGICAL X OPERATOR

FIG. 4

FIG. 5

32 LOGICAL QUBIT

34a 33e

33a

Z ERROR

34c
33c

33b
34b

33d

32c
LOGICAL X
OPERATOR

GENERATE
DECODE GRAPH

ESTIMATED
Z ERROR

ACTUAL
Z ERROR

35 DECODE GRAPH

34d

FIG. 6

EP 4 738 207 A1

FIG. 7

32  LOGICAL QUBIT

34j

34b

34i

34c

32c

LOGICAL X
OPERATOR

GENERATE
DECODE GRAPH

ERROR
WEIGHT

37  DECODE GRAPH

37b

| 0.1 | 0.01 | 0.1 | 0.5 | 0.5 |

| 0.1 | 0.1 | 0.1 | 0.2 |

| 0.3 | 25 | 15 | 0.1 | 0.5 |

| 0.5 | 10 | 20 | 0.1 |

| 0.4 | 5 | 30 | 0.1 | 0.7 |

| 10 | 0.1 | 0.1 |

37d

37c

37a     37e

FIG. 8

FIG. 9

FIG. 10

35 DECODE GRAPH

$$H = -J \sum_v^{|V|} b_v \prod_{e \in \delta v} \sigma_e - h \sum_e^{|E|} \sigma_e$$

35

## FIG. 11

CLASSICAL
COMPUTER
（SERVER） ⌒ 100

CONTROL
DEVICE ⌒ 210

ERROR DETECTION
UNIT ⌒ 214

GRAPH
CONSTRUCTION
UNIT ⌒ 214a

STORAGE UNIT ⌒ 214b

DECODER ⌒ 214c

QUBIT DEVICE
MANAGEMENT UNIT ⌒ 211

MEASUREMENT RESULT
ACQUISITION UNIT ⌒ 213

GATE OPERATION
UNIT ⌒ 212

HIGH-FREQUENCY SIGNAL GENERATION DEVICE ⌒ 230

QUBIT DEVICE ⌒ 220

# FIG. 12

START

S101
RECEIVE GATE OPERATION
REQUEST BASED ON
QUANTUM CIRCUIT

S102
DECODE GRAPH REGION
DIVIDING PROCESS

S103
GATE OPERATION OR
MEASUREMENT

S104
HAVE
RESULTS OF SYNDROME
MEASUREMENT FOR PREDETERMINED
NUMBER OF TIMES BEEN
ACQUIRED? — NO

YES

S105
DECODING PROCESS

S106
HAS ERROR OCCURRED
IN LOGICAL QUBIT? — NO

YES

S107
RECORD ERROR

S108
IS EXECUTION
OF QUANTUM CIRCUIT
COMPLETED? — NO

YES

S109
OUTPUT MEASUREMENT
RESULT CORRECTED BASED
ON ERROR

END

FIG. 13

DECODE GRAPH REGION
DIVIDING PROCESS
START

DIVIDE REGION OF DECODE GRAPH
INTO SUBREGIONS — S121

ASSIGN ADDRESS (i,j,k) TO EACH
SUBREGION — S122

CALCULATE AVERAGE WEIGHT
VALUE FOR EACH SUBREGION — S123

END

# FIG. 14

TIME

51 52

SYNDROME MEASUREMENT:
SECOND TIME

SYNDROME MEASUREMENT: FIRST TIME

51a

Y AXIS

X AXIS

60

Y AXIS TIME AXIS

X AXIS

FIG. 15

60

61a          61b

Y AXIS          TIME AXIS

FIG. 16

X AXIS

62

α

FIG. 17

FIG. 18

62

$\overline{W}_{(0,0,0)}$ $\overline{W}_{(1,0,0)}$ $\overline{W}_{(2,0,0)}$ $\overline{W}_{(3,0,0)}$

$\overline{W}_{(0,1,0)}$ $\overline{W}_{(1,1,0)}$ $\overline{W}_{(2,1,0)}$ $\overline{W}_{(3,1,0)}$

$\overline{W}_{(0,2,0)}$ $\overline{W}_{(1,2,0)}$ $\overline{W}_{(2,2,0)}$ $\overline{W}_{(3,2,0)}$

$\overline{W}_{(0,3,0)}$ $\overline{W}_{(1,3,0)}$ $\overline{W}_{(2,3,0)}$ $\overline{W}_{(3,3,0)}$

FIG. 19

DECODING PROCESS START

S131 — SELECT VERTEX $S_i$ OF INVERTED DIFFERENCE SYNDROME

S132 — SELECT, AS $S_j$, VERTEX OF ANOTHER DIFFERENCE SYNDROME ADJACENT TO $S_i$, IN ORDER OF CLOSENESS

S133 — IS DIFFERENCE BETWEEN ADDRESSES OF $S_i$ AND $S_j$ LESS THAN OR EQUAL TO $\gamma$?

NO → S134 — CONNECT $S_i$ AND $S_j$ WITH EDGE, USING VALUE OBTAINED BY APPROXIMATION CALCULATION AS WEIGHT

YES → S135 — CONNECT $S_i$ AND $S_j$ WITH EDGE, USING VALUE OBTAINED BY HIGH-PRECISION CALCULATION AS WEIGHT

S136 — HAS DEGREE OF $S_i$ REACHED $\beta$?

NO / YES

S137 — HAVE ALL VERTICES OF INVERTED DIFFERENCE SYNDROMES BEEN SELECTED?

NO / YES

S138 — PERFORM DECODING USING GENERATED GRAPH

END

FIG. 20

FIG. 21

FIG. 22

FIG. 23

FIG. 24

| | Europäisches Patentamt European Patent Office Office européen des brevets | **EUROPEAN SEARCH REPORT** | **Application Number** EP 25 21 1514 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | FORLIVESI DIEGO ET AL: "Spanning Tree Matching Decoder for Quantum Surface Codes", IEEE COMMUNICATIONS LETTERS, IEEE SERVICE CENTER, PISCATAWAY, NJ, US, vol. 28, no. 7, 3 May 2024 (2024-05-03), pages 1509-1513, XP011975771, ISSN: 1089-7798, DOI: 10.1109/LCOMM.2024.3396882 [retrieved on 2024-05-06] | 1-3,6-8 | INV. G06N10/70 |
| A | * page 1509 - page 1512; figures 1-3; table 1 * ----- | 4,5 | |

| | | | TECHNICAL FIELDS SEARCHED (IPC) |
|---|---|---|---|
| | | | G06N |

The present search report has been drawn up for all claims

| Place of search | Date of completion of the search | Examiner |
|---|---|---|
| The Hague | 11 March 2026 | Cilia, Elisa |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P4C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2024059124 A
- JP 2022553169 A
- US 20220382632
- US 11847020 B

**Non-patent literature cited in the description**

- **BEN BARBER et al.** A real-time, scalable, fast and highly resource efficient decoder for a quantum computer. *arXiv: 2309.05558v2, quant-ph*, 24 September 2024